# EUROPEAN PATENT SPECIFICATION

(11) **EP 4 152 423 B1**
(45) Date of publication and mention of the grant of the patent: **22.07.2026**
(21) Application number: 21197750.9
(22) Date of filing: 20.09.2021
(51) Int. Cl.: H10K 85/30, H10K 50/818, H10K 50/17

(54) **ORGANIC ELECTRONIC DEVICE COMPRISING AT LEAST ONE METAL COMPLEX OF FORMULA (I)**
ORGANISCHE ELEKTRONISCHE VORRICHTUNG MIT MINDESTENS EINEM METALLKOMPLEX DER FORMEL (I)
DISPOSITIF ÉLECTRONIQUE ORGANIQUE COMPRENANT AU MOINS UN COMPLEXE MÉTALLIQUE DE FORMULE (I)

(43) Date of publication of application: 22.03.2023
(73) Proprietor: Novaled GmbH, 01099 Dresden (DE)
(72) Inventor: Uvarov, Vladimir, 01099 Dresden (DE); Willmann, Steffen, 01099 Dresden (DE); Heggemann, Ulrich, 01099 Dresden (DE)
(74) Representative: Michalski Hüttermann & Partner mbB

(56) References cited:
- EP-A1- 3 945 090
- EP-A1- 3 945 125
- WO-A1-2016/188604
- CN-A- 111 018 921
- DE-A1- 102017 207 327
- US-A1- 2011 031 876
- "Photoelectron Spectrophotometer in air. Surface Analyzer. Model AC-3", 11 June 2012 (2012-06-11), pages 1 - 6, XP055029420, Retrieved from the Internet <URL:http://www.rkiinstruments.com/pdf/AC3.pdf> [retrieved on 20120611]

## Description

### Technical Field

The present invention relates to an organic electronic device comprising at least one metal complex of formula (I).

### Background Art

Electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds

EP 3 945090 A1 refers to metal complexes of 3-(2,3,5-trifluoro-6-(trifluoromethyl)pyridin-4-yl)pentane-2,4-dione and similar ligands as semiconductor materials for use in electronic devices.

EP 3 945 125 A1 refers to metal complexes as semiconductor materials for use in electronic devices.

"Photoelectron Spectrophotometer in air. Surface Analyzer. Model AC-3", 11 June 2012 (2012-06-11 ), pages 1-6, XP055029420.

CN 111 018 921 A refers to metal complexes for hole injection layers in organic light-emitting diodes.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

Performance of an organic light emitting diode may be affected by characteristics of the hole injection layer, and among them, may be affected by characteristics of the hole transport compound and the metal complexes which are contained in the hole injection layer.

Performance of an organic light emitting diode may be affected by characteristics of the semiconductor layer, and among them, may be affected by characteristics of metal complexes which are also contained in the semiconductor layer.

There remains a need to improve performance of semiconductor materials, semiconductor layers, as well as electronic devices thereof, in particular to achieve improved operating voltage stability over time through improving the characteristics of the compounds comprised therein.

Further there remains a need to improve performance of electronic devices by providing hole injection layers with improved performance, in particular to achieve improved operating voltage stability over time and/or efficiency through improving the characteristics of the hole injection layer and the electronic device.

### DISCLOSURE

An aspect of the present invention provides an organic electronic device comprising a substrate, an anode layer, a cathode layer, at least one first emission layer, and a hole injection layer, wherein the hole injection layer comprises a metal complex, wherein the metal complex has the formula (I): 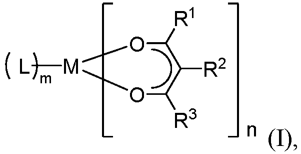 wherein
- M: is a metal;
- L: is a charge-neutral ligand, which coordinates to the metal M;
- n: is an integer selected from 1 to 4, which corresponds to the oxidation number of M;
- m: is an integer selected from 0 to 2;
- R¹ and R³: are independently selected from H, D, substituted or unsubstituted C₁ to C₁₂ alkyl, substituted or unsubstituted C₁ to C₁₂ alkoxy, substituted or unsubstituted C₆ to C₂₄ aryl, and substituted or unsubstituted C₂ to C₂₄ heteroaryl group, wherein
at least one substituent is selected from halogen, F, Cl, CN, substituted or unsubstituted C₁ to C₁₂ alkyl, partially or fully fluorinated C₁ to C₁₂ alkyl, substituted or unsubstituted C₁ to C₁₂ alkoxy, partially or fully fluorinated C₁ to C₁₂ alkoxy, substituted or unsubstituted C₆ to C₁₈ aryl, and substituted or unsubstituted C₂ to C₁₈ heteroaryl, wherein
the substituents of the substituted or unsubstituted C₁ to C₁₂ alkyl, substituted or unsubstituted C₁ to C₁₂ alkoxy, substituted or unsubstituted C₆ to C₁₈ aryl, and substituted or unsubstituted C₂ to C₁₈ heteroaryl are selected from halogen, F, Cl, CN, C₁ to C₆ alkyl, CF₃, OCH₃, OCF₃;
- R²: is selected from CN, C₁ to C₄ alkyl, partially or perfluorinated C₁ to C₄ alkyl, or F;

- the anode layer comprises a first anode sub-layer and a second anode sub-layer,
   wherein
   - the first anode sub-layer comprises a first metal having a work function in the range of ≥ 4 and ≤ 6 eV,
   - the second anode sub-layer comprises a transparent conductive oxide;
   - the hole injection layer is arranged between the first emission layer and the anode layer,
   - the first anode sub-layer is arranged closer to the substrate, and
   - the second anode sub-layer is arranged closer to the hole injection layer;
- wherein the compounds A1 to A18 are excluded from Formula (I):

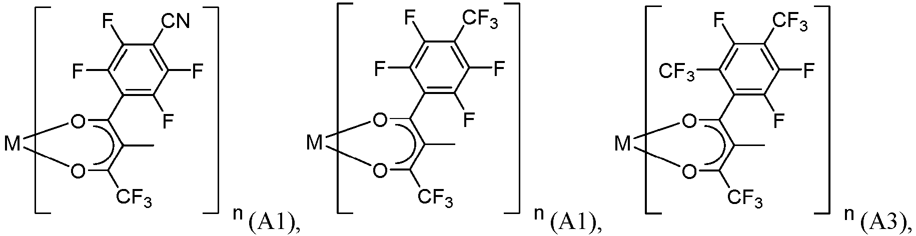

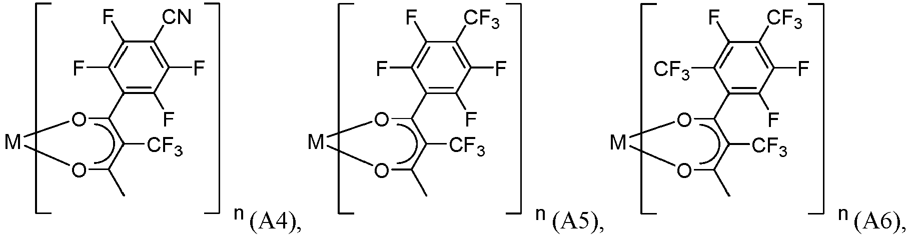

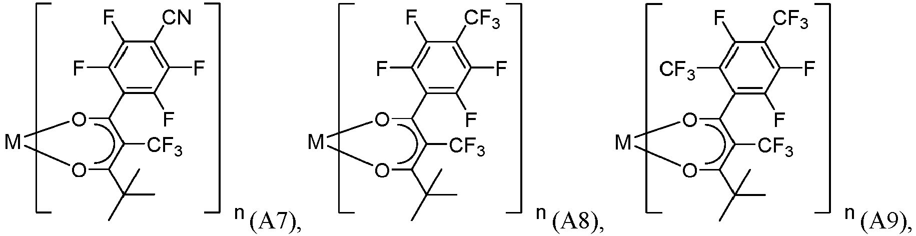

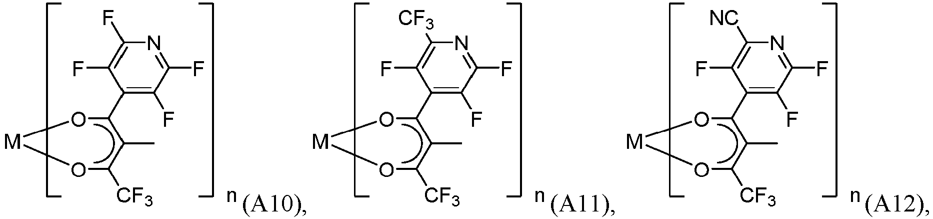

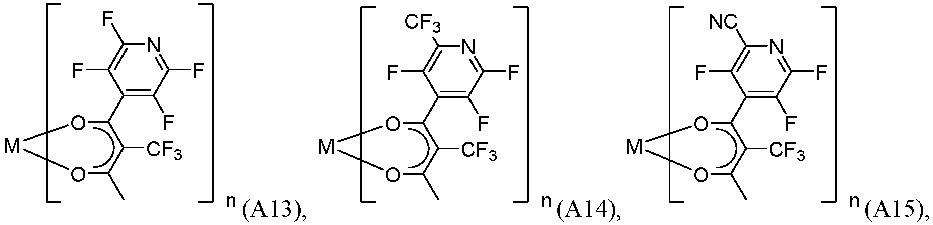

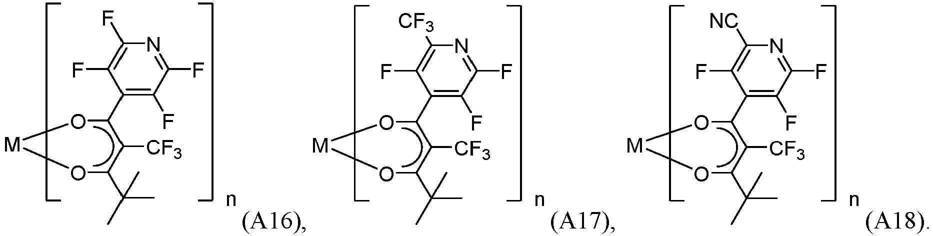

### Definitions

It should be noted that throughout the application and the claims any R¹, R², R³, L and M. always refer independently from each other to the same moieties according to their definition, unless otherwise noted.

In the present specification, when a definition is not otherwise provided, "substituted" refers to a substituted selected from substituted or unsubstituted C₁ to C₁₂ alkyl, partially or fully fluorinated C₁ to C₁₂ alkyl, substituted or unsubstituted C₁ to C₁₂ alkoxy, partially or fully fluorinated C₁ to C₁₂ alkoxy, substituted or unsubstituted C₆ to C₁₈ aryl, and substituted or unsubstituted C₂ to C₁₈ heteroaryl, wherein the substituents are selected from the substituents of the substituted or unsubstituted C₁ to C₁₂ alkyl, substituted or unsubstituted C₁ to C₁₂ alkoxy, substituted or unsubstituted C₆ to C₁₈ aryl, and substituted or unsubstituted C₂ to C₁₈ heteroaryl are selected from halogen, F, Cl, CN, C₁ to C₆ alkyl, CF₃, OCH₃, OCF₃.

In the present specification, "aryl group" and "aromatic rings" refers to a hydrocarbyl group which may be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under "heteroaryl" and "heteroaromatic", it is especially where suitable understood a group derived by formal abstraction of one ring hydrogen from a heterocyclic aromatic ring in a compound comprising at least one such ring.

The term "non-heterocycle" is understood to mean a ring or ring-system comprising no hetero-atom as a ring member.

The term "heterocycle" is understood to mean that the heterocycle comprises at least one ring comprising one or more hetero-atoms. A heterocycle comprising more than one ring means that all rings comprising a hetero-atom or at least one ring comprising a hetero atom and at least one ring comprising C-atoms only and no hetero atom. A C₂ heteroaryl group means that an heteroaryl ring comprises two C-Atoms and the other atoms are hetero-atoms.

Under heterocycloalkyl, it is especially where suitable understood a group derived by formal abstraction of one ring hydrogen from a saturated cycloalkyl ring in a compound comprising at least one such ring.

The term "aryl" having at least 9 C-atoms may comprise at least one fused aryl ring. The term "heteroaryl" having at least 9 atoms may comprise at least one fused heteroaryl ring fused with a heteroaryl ring or fused with an aryl ring.

The term "fused aryl rings" or "condensed aryl rings" is understood the way that two aryl rings are considered fused or condensed when they share at least two common sp²-hybridized carbon atoms.

The term "fused ring system" is understood to mean a ring system wherein two or more rings share at least two atoms.

The term "5-, 6- or 7-member ring" is understood to mean a ring comprising 5, 6 or 7 atoms. The atoms may be selected from C and one or more hetero-atoms.

In the present specification, the single bond refers to a direct bond.

In the present specification, when a definition is not otherwise provided, "substituted" refers to one substituted with a H, deuterium, C₁ to C₁₂ alkyl, unsubstituted C₆ to C₁₈ aryl, and unsubstituted C₂ to C₁₈ heteroaryl.

In the present specification "substituted aryl" refers for example to a C₆ to C₂₄ aryl or C₆ to C₁₈ aryl that is substituted with one or more substituents, wherein the substituent may be substituted with none, one or more substituents.

Correspondingly, in the present specification "substituted heteroaryl substituted" refers to a substitution with one or more substituents, which themselves may be substituted with one or more substituents.

In the present specification, when a definition is not otherwise provided, a substituted heteroaryl group with at least 2 C-ring atoms may be substituted with one or more substituents. For example, a substituted C₂ heteroaryl group may have 1 or 2 substituents.

A substituted aryl group with at least 6 ring atoms may be substituted with 1, 2, 3, 4 or 5 substituents.

A substituted heteroaryl group may comprise at least 6 ring atoms. A substituted heteroaryl group that may comprise at least 6 ring atoms may be substituted with 1, 2, 3 or 4 substituents, if the heteroaryl group comprises one hetero atom and five C-atoms, or it may be substituted with 1, 2 or 3 substituents, if the heteroaryl group with at least 6 ring atoms comprises two hetero atom and four C-atoms, or may be substituted with 1 or 2 substituents, if the heteroaryl group with at least 6 ring atoms comprises three hetero atoms and three C-atoms, wherein the substituent is bonded to the C-ring atoms only.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, tert-butyl, cyclohexyl.

Specific examples of the alkyl group may be a methyl group, an ethyl group, a propyl group, an iso-propyl group, a butyl group, an iso-butyl group, a sec-butyl group, a tert-butyl group, a pentyl group, a branched pentyl group, a hexyl group, a cyclopropyl group, a cyclobutyl group, a cyclopentyl group, a cyclohexyl group, an adamantly group and the like.

In the present specification, when a definition is not otherwise provided, a "substituted alkyl group" may refer to a linear, branched or cyclic substituted saturated aliphatic hydrocarbyl group. The substituted alkyl group may be a linear, branched or cyclic C₁ to C₁₂ alkyl group. More specifically, the substituted alkyl group may be a linear, branched or cyclic substituted C₁ to C₁₀ alkyl group or a linear, branched or cyclic substituted C₁ to C₆ alkyl group. For example, a linear, branched or cyclic substituted C₁ to C₄ alkyl group includes 1 to 4 carbons in the alkyl chain, and may be selected from methyl, ethyl, propyl, iso-propyl, n-butyl, iso-butyl, sec-butyl, tert-butyl and cyclohexyl. The substituents may be selected from halogen, F, Cl, CN, OCH₃, OCF₃.

The term "hetero" is understood the way that at least one carbon atom, in a structure which may be formed by covalently bound carbon atoms, is replaced by another polyvalent atom. Preferably, the heteroatoms are selected from B, Si, N, P, O, S; further preferred from N, P, O, S and most preferred N.

In the present specification, when a substituent is not named, the substituent may be a H.

The term "charge-neutral" means that the group L is overall electrically neutral.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms anode, anode layer and anode electrode are used synonymously.

The term "at least two anode sub-layers" is understood to mean two or more anode sub-layers, for example two or three anode sub-layers.

The terms cathode, cathode layer and cathode electrode are used synonymously.

The term "hole injection layer" is understood to mean a layer which improves charge injection from the anode layer into further layers in the electronic device or from further layers of the electronic device into the anode.

The term "hole transport layer" is understood to mean a layer which transports holes between the hole injection layer and further layers arranged between the hole injection layer and the cathode layer.

The operating voltage U is measured in Volt.

In the context of the present specification the term "essentially non-emissive" or "non-emissive" means that the contribution of the compound of formula (I) or the hole injection layer comprising a compound of formula (I), to the visible emission spectrum from an electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

In the context of the present invention, the term "sublimation " may refer to a transfer from solid state to gas phase or from liquid state to gas phase.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The term "HOMO level" is understood to mean the highest occupied molecular orbital and is determined in eV (electron volt).

The term "HOMO level further away from vacuum level" is understood to mean that the absolute value of the HOMO level is higher than the absolute value of the HOMO level of the reference compound. For example, the term "further away from vacuum level than the HOMO level of N2,N2,N2',N2',N7,N7,N7',N7'-octakis(4-methoxyphenyl)-9,9'-spirobi[fluorene]-2,2',7,7'-tetraamine is understood to mean that the absolute value of the HOMO level of the matrix compound of the hole injection layer is higher than the HOMO level of N2,N2,N2',N2', N7,N7, N7',N7'-octakis(4-methoxyphenyl)-9,9'-spirobi[fluorene]-2,2',7,7'-tetraamine.

The term "absolute value" is understood to mean the value without the "- "symbol. According to one embodiment of the present invention, the HOMO level of the matrix compound of the hole injection layer may be calculated by quantum mechanical methods.

### Advantageous Effects

Surprisingly, it was found that the electronic device according to the invention solves the problem underlying the present invention by enabling electronic devices, such as organic light-emitting diodes, in various aspects superior over the electronic devices known in the art, in particular with respect to operating voltage stability over time and/or efficiency.

The metal complex of Formula (I) is non-emissive. In the context of the present specification the term "essentially non-emissive" or "non-emissive" means that the contribution of the metal complex of formula (I) to the visible emission spectrum from an electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

### M of the metal complex of Formula (I)

The term "M" represents a metal. According to one embodiment, the metal M may be selected from alkali, alkaline earth, transition, rare earth metal or group III to V metal, preferably the metal M is selected from transition or group III to V metal; preferably the metal M is selected from Li(I), Na(I), K(I), Rb(I), Cs(I), Cu(II), Zn(II), Pd(II), Al(III), Sc(III), Mn(III), In(III), Y(III), Eu(III), Fe(III), Zr(IV), Hf(IV) or Ce(IV), more preferred M is Cu(II) or Fe(III), and further more preferred M is Cu(II). Elements of groups IV-XI are named transition metals.

### Ligand L of formula (I)

The term "L" represents a charge-neutral ligand, which coordinates to the metal M. According to one embodiment L is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile or C₂ to C₄₀ aryl nitrile, or a compound according to Formula (II); 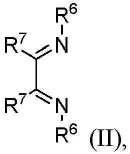 wherein
- R⁶ and R⁷: are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

According to one embodiment, wherein the ligand L in compound of Formula (I) may be selected from a group comprising:
- at least three carbon atoms, alternatively at least four carbon atoms, and/or
- at least two oxygen atoms or one oxygen and one nitrogen atom, two to four oxygen atoms, two to four oxygen atoms and zero to two nitrogen atoms, and/or
- at least one or more groups selected from halogen, F, CN, substituted or unsubstituted C₁ to C₆ alkyl, substituted or unsubstituted C₁ to C₆ alkoxy, alternatively two or more groups selected from halogen, F, CN, substituted or unsubstituted C₁ to C₆ alkyl, substituted or unsubstituted C₁ to C₆ alkoxy, at least one or more groups selected from halogen, F, CN, substituted C₁ to C₆ alkyl, substituted C₁ to C₆ alkoxy, alternatively two or more groups selected from halogen, F, CN, perfluorinated C₁ to C₆ alkyl, perfluorinated C₁ to C₆ alkoxy, one or more groups selected from substituted or unsubstituted C₁ to C₆ alkyl, substituted or unsubstituted C₆ to C₁₂ aryl, and/or substituted or unsubstituted C₃ to C₁₂ heteroaryl,
   wherein the substituents are selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR³, COOR³, halogen, F or CN;
   wherein R³ may be selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy.

### The term "n"

The term "n" is an integer selected from 1 to 4, which corresponds to the oxidation number of M. According to one embodiment "n" is an integer selected from 1, 2 and 3, which corresponds to the oxidation number of M. According to one embodiment "n" is an integer selected from 1 or 2. According to another embodiment "n" is an integer selected from 1 or 3. According to another embodiment "n" is an integer selected from 2 or 3. Preferably "n" may be selected 2.

### The term "m"

The term "m" is an integer selected from 0 to 2, which corresponds to the oxidation number of M. According to one embodiment "m" is an integer selected from 0 or 1. According to another embodiment "m" is an integer selected from 1 or 2. According to another embodiment "m" is an integer selected from 0 or 2.

### Embodiments

The metal complex represented by Formula (I) can be also named metal complex or metal acetylacetonate complex.

According to one embodiment, the metal complex of Formula (I) may have a molecular weight Mw of ≥ 287 g/mol and ≤ 2000 g/mol, preferably a molecular weight Mw of ≥ 400 g/mol and ≤ 1500 g/mol, further preferred a molecular weight Mw of ≥ 580 g/mol and ≤ 1500 g/mol, in addition preferred a molecular weight Mw of ≥ 580 g/mol and ≤ 1400 g/mol, in addition preferred a molecular weight Mw of ≥ 580 g/mol and ≤ 1100 g/mol.

According to the claimed invention the compounds A1 to A18 are excluded from Formula (I):

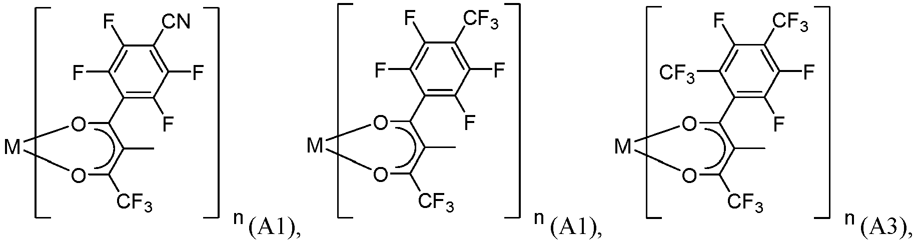

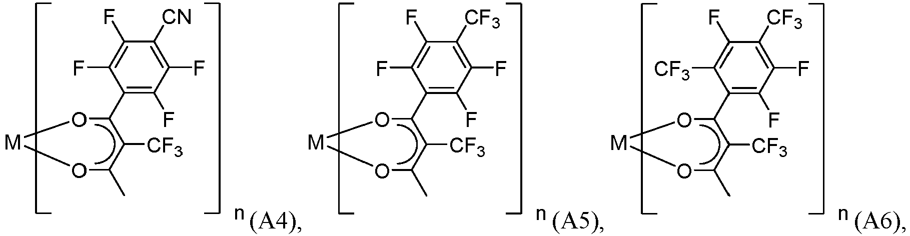

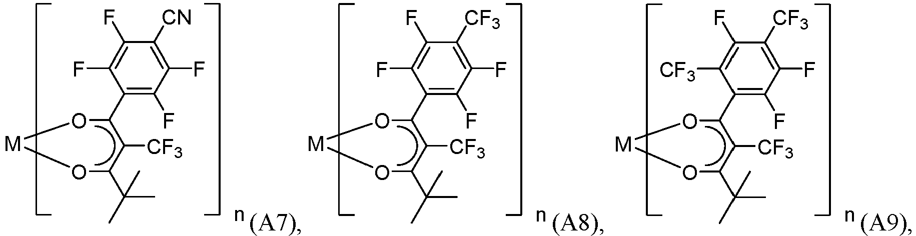

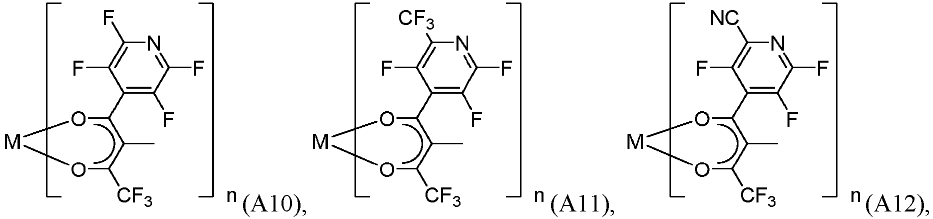

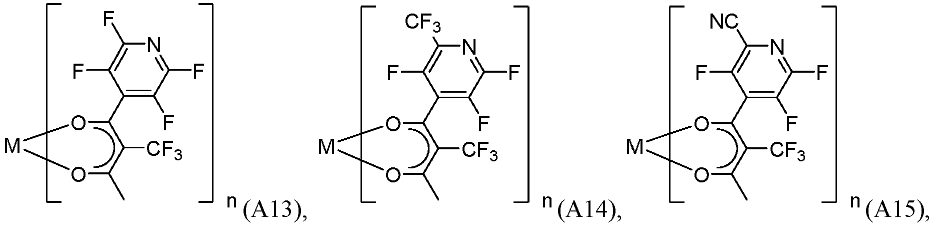

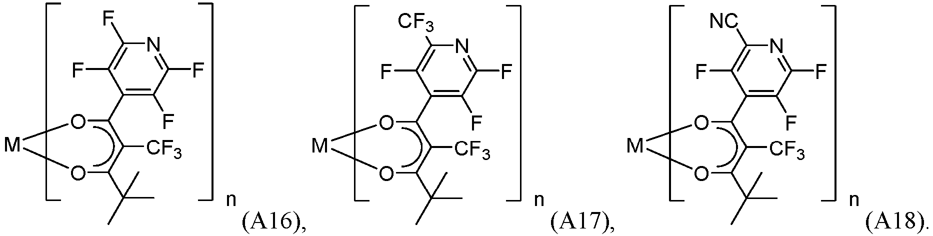

According to one embodiment, wherein the organic electronic device comprises a substrate, an anode layer, a cathode layer, at least one first emission layer, and a hole injection layer, wherein the hole injection layer comprises a metal complex, wherein the metal complex has the formula (I): 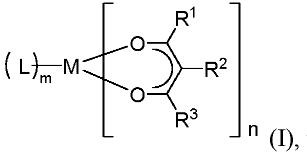 wherein
- M: is a metal;
- L: is a charge-neutral ligand, which coordinates to the metal M;
- n: is an integer selected from 1 to 4, which corresponds to the oxidation number of M;
- m: is an integer selected from 0 to 2;
- R¹ and R³: are independently selected from H, D, substituted or unsubstituted C₁ to C₁₂ alkyl, substituted or unsubstituted C₁ to C₁₂ alkoxy, substituted or unsubstituted C₆ to C₂₄ aryl, and substituted or unsubstituted C₂ to C₂₄ heteroaryl group, wherein
at least one substituent is selected from halogen, F, Cl, CN, substituted or unsubstituted C₁ to C₁₂ alkyl, partially or fully fluorinated C₁ to C₁₂ alkyl, substituted or unsubstituted C₁ to C₁₂ alkoxy, partially or fully fluorinated C₁ to C₁₂ alkoxy, substituted or unsubstituted C₆ to C₁₈ aryl, and substituted or unsubstituted C₂ to C₁₈ heteroaryl, wherein
the substituents of the substituted or unsubstituted C₁ to C₁₂ alkyl, substituted or unsubstituted C₁ to C₁₂ alkoxy, substituted or unsubstituted C₆ to C₁₈ aryl, and substituted or unsubstituted C₂ to C₁₈ heteroaryl are selected from halogen, F, Cl, CN, C₁ to C₆ alkyl, CF₃, OCH₃, OCF₃;
- R²: is selected from CN, C₁ to C₄ alkyl, partially or perfluorinated C₁ to C₄ alkyl, or F;

- the anode layer comprises a first anode sub-layer and a second anode sub-layer,
   wherein
   - the first anode sub-layer comprises a first metal having a work function in the range of ≥ 4 and ≤ 6 eV,
   - the second anode sub-layer comprises a transparent conductive oxide;
   - the hole injection layer is arranged between the first emission layer and the anode layer,
   - the first anode sub-layer is arranged closer to the substrate, and
   - the second anode sub-layer is arranged closer to the hole injection layer;
and wherein the compounds A1 to A18 are excluded.

According to one embodiment, wherein the organic electronic device comprises a substrate, an anode layer, a cathode layer, at least one first emission layer, and a hole injection layer, wherein the hole injection layer comprises a metal complex, wherein the metal complex has the formula (I): 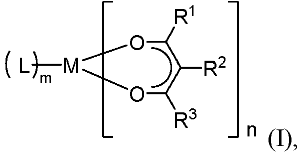 wherein
- M: is a metal;
- L: is a charge-neutral ligand, which coordinates to the metal M;
- n: is an integer selected from 1 to 4, preferably 2, which corresponds to the oxidation number of M;
- m: is an integer selected from 0 to 2;
- R¹ and R³: are independently selected from a substituted C₆ to C₂₄ aryl or substituted C₂ to C₂₄ heteroaryl group, wherein at least one substituent or at least two substituents of the substituted C₆ to C₂₄ aryl or substituted C₂ to C₂₄ heteroaryl group is selected from CN or partially or fully fluorinated C₁ to C₁₂ alkyl, preferably partially or fully fluorinated C₁ to C₄ alkyl, and more preferred selected from CN CF₃, C₂F₅ or C₃F₇;
- R²: is selected from CN, CH₃, CF₃, C₂F₅, C₃F₇ or F, more preferred CN, CH₃, CF₃, C₂F₅, C₃F₇;

- the anode layer comprises a first anode sub-layer and a second anode sub-layer, wherein
   - the first anode sub-layer comprises a first metal having a work function in the range of ≥ 4 and ≤ 6 eV,
   - the second anode sub-layer comprises a transparent conductive oxide;
   - the hole injection layer is arranged between the first emission layer and the anode layer,
   - the first anode sub-layer is arranged closer to the substrate, and
   - the second anode sub-layer is arranged closer to the hole injection layer;
and optionel the compounds A1 to A18 are excluded.

According to one embodiment the organic electronic device comprising a substrate, an anode layer, a cathode layer, at least one first emission layer, and a hole injection layer, wherein the hole injection layer comprises a metal complex, wherein the metal complex has the formula (Ia): 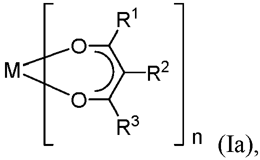 wherein
- M: is a metal;
- n: is an integer selected from 1 to 4, preferably 2, which corresponds to the oxidation number of M;
- R¹ and R³: are independently selected from H, D, substituted or unsubstituted C₁ to C₁₂ alkyl, substituted or unsubstituted C₁ to C₁₂ alkoxy, substituted or unsubstituted C₆ to C₂₄ aryl, and substituted or unsubstituted C₂ to C₂₄ heteroaryl group, wherein
at least one substituent is selected from halogen, F, Cl, CN, substituted or unsubstituted C₁ to C₁₂ alkyl, partially or fully fluorinated C₁ to C₁₂ alkyl, substituted or unsubstituted C₁ to C₁₂ alkoxy, partially or fully fluorinated C₁ to C₁₂ alkoxy, substituted or unsubstituted C₆ to C₁₈ aryl, and substituted or unsubstituted C₂ to C₁₈ heteroaryl, wherein
the substituents of the substituted or unsubstituted C₁ to C₁₂ alkyl, substituted or unsubstituted C₁ to C₁₂ alkoxy, substituted or unsubstituted C₆ to C₁₈ aryl, and substituted or unsubstituted C₂ to C₁₈ heteroaryl are selected from halogen, F, Cl, CN, C₁ to C₆ alkyl, CF₃, OCH₃, OCF₃;
- R²: is selected from CN, C₁ to C₄ alkyl, partially or perfluorinated C₁ to C₄ alkyl, or F;

- the anode layer comprises a first anode sub-layer and a second anode sub-layer,
   wherein
   - the first anode sub-layer comprises a first metal having a work function in the range of ≥ 4 and ≤ 6 eV,
   - the second anode sub-layer comprises a transparent conductive oxide;
   - the hole injection layer is arranged between the first emission layer and the anode layer,
   - the first anode sub-layer is arranged closer to the substrate, and
   - the second anode sub-layer is arranged closer to the hole injection layer.

According to one embodiment the organic electronic device comprising a substrate, an anode layer, a cathode layer, at least one first emission layer, and a hole injection layer, wherein the hole injection layer comprises a metal complex, wherein the metal complex has the formula (Ia): 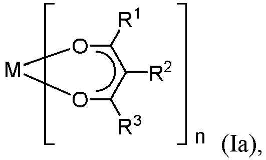 wherein
- M: is a metal;
- n: is an integer selected from 1 to 4, preferably 2, which corresponds to the oxidation number of M;
- R¹ and R³: are independently selected from H, D, substituted or unsubstituted C₁ to C₁₂ alkyl, substituted or unsubstituted C₁ to C₁₂ alkoxy, substituted or unsubstituted C₆ to C₂₄ aryl, and substituted or unsubstituted C₂ to C₂₄ heteroaryl group, wherein at least one substituent is selected from halogen, F, Cl, CN, substituted or unsubstituted C₁ to C₁₂ alkyl, partially or fully fluorinated C₁ to C₁₂ alkyl, substituted or unsubstituted C₁ to C₁₂ alkoxy, partially or fully fluorinated C₁ to C₁₂ alkoxy, substituted or unsubstituted C₆ to C₁₈ aryl, and substituted or unsubstituted C₂ to C₁₈ heteroaryl, wherein
the substituents of the substituted or unsubstituted C₁ to C₁₂ alkyl, substituted or unsubstituted C₁ to C₁₂ alkoxy, substituted or unsubstituted C₆ to C₁₈ aryl, and substituted or unsubstituted C₂ to C₁₈ heteroaryl are selected from halogen, F, Cl, CN, C₁ to C₆ alkyl, CF₃, OCH₃, OCF₃;
- R²: is selected from CN, C₁ to C₄ alkyl, partially or perfluorinated C₁ to C₄ alkyl, or F;

- the anode layer comprises a first anode sub-layer and a second anode sub-layer,
   wherein
   - the first anode sub-layer comprises a first metal having a work function in the range of ≥ 4 and ≤ 6 eV,
   - the second anode sub-layer comprises a transparent conductive oxide;
   - the hole injection layer is arranged between the first emission layer and the anode layer,
   - the first anode sub-layer is arranged closer to the substrate, and
   - the second anode sub-layer is arranged closer to the hole injection layer;
and wherein the compounds A1 to A18 are excluded.

According to one embodiment at least one R¹ and/or R³ is selected from a substituted C₆ to C₂₄ aryl or substituted C₂ to C₂₄ heteroaryl group, wherein at least one substituent or at least two substituents of the substituted C₆ to C₂₄ aryl or substituted C₂ to C₂₄ heteroaryl group is selected from CN or partially or fully fluorinated C₁ to C₁₂ alkyl, preferably partially or fully fluorinated C₁ to C₄ alkyl, and more preferred selected from CN CF₃, C₂F₅ or C₃F₇.

According to one embodiment R² is selected from CN, CH₃, CF₃, C₂F₅, C₃F₇ or F, more preferred CN, CH₃, CF₃, C₂F₅, C₃F₇.

According to one embodiment the organic electronic device comprising a substrate, an anode layer, a cathode layer, at least one first emission layer, and a hole injection layer, wherein the hole injection layer comprises a metal complex, wherein the metal complex has the formula (Ia): 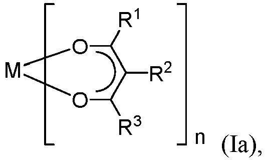 wherein
- M: is a metal;
- n: is an integer selected from 1 to 4, preferably 2, which corresponds to the oxidation number of M;
- R¹ and R³: are independently selected from a substituted C₆ to C₂₄ aryl or substituted C₂ to C₂₄ heteroaryl group, wherein at least one substituent or at least two substituents of the substituted C₆ to C₂₄ aryl or substituted C₂ to C₂₄ heteroaryl group is selected from CN or partially or fully fluorinated C₁ to C₁₂ alkyl, preferably partially or fully fluorinated C₁ to C₄ alkyl, and more preferred selected from CN CF₃, C₂F₅ or C₃F₇;
- R²: is selected from is selected from CN, CH₃, CF₃, C₂F₅, C₃F₇ or F, more preferred CN, CH₃, CF₃, C₂F₅, C₃F₇;

- the anode layer comprises a first anode sub-layer and a second anode sub-layer,
   wherein
   - the first anode sub-layer comprises a first metal having a work function in the range of ≥ 4 and ≤ 6 eV,
   - the second anode sub-layer comprises a transparent conductive oxide;
   - the hole injection layer is arranged between the first emission layer and the anode layer,
   - the first anode sub-layer is arranged closer to the substrate, and
   - the second anode sub-layer is arranged closer to the hole injection layer.

According to one embodiment the organic electronic device comprising a substrate, an anode layer, a cathode layer, at least one first emission layer, and a hole injection layer, wherein the hole injection layer comprises a metal complex, wherein the metal complex has the formula (Ia): 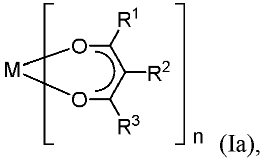 wherein
- M: is Cu(II) or Fe(III);
- n: is an integer selected from 1 to 4, preferably 2, which corresponds to the oxidation number of M;
- R¹ and R³: are independently selected from a substituted C₆ to C₂₄ aryl or substituted C₂ to C₂₄ heteroaryl group, wherein at least one substituent or at least two substituents of the substituted C₆ to C₂₄ aryl or substituted C₂ to C₂₄ heteroaryl group is selected from CN or partially or fully fluorinated C₁ to C₁₂ alkyl, preferably partially or fully fluorinated C₁ to C₄ alkyl, and more preferred selected from CN CF₃, C₂F₅ or C₃F₇;
- R²: is selected from is selected from CN, CH₃, CF₃, C₂F₅, C₃F₇ or F, more preferred CN, CH₃, CF₃, C₂F₅, C₃F₇;

- the anode layer comprises a first anode sub-layer and a second anode sub-layer,
   wherein
   - the first anode sub-layer comprises a first metal having a work function in the range of ≥ 4 and ≤ 6 eV,
   - the second anode sub-layer comprises a transparent conductive oxide;
   - the hole injection layer is arranged between the first emission layer and the anode layer,
   - the first anode sub-layer is arranged closer to the substrate, and
   - the second anode sub-layer is arranged closer to the hole injection layer;
and optional wherein the compounds A1 to A18 are excluded.

According to one embodiment R² is selected from CN, CH₃, CF₃ or F.

According to one embodiment the metal complex of formula (I) comprises at least one CF₃ group, preferably at least two CF₃ groups, further preferred at least three CF₃ groups, in addition preferred at least four CF₃ groups or at least two CF₃ groups and at least one C₂F₅ and at least one CN group.

According to one embodiment, wherein at least one R¹ or R³ are selected from a substituted C₂ to C₂₄ heteroaryl group, wherein
- the substituted heteroaryl group comprises at least one six-membered ring; and/or
- the substituted heteroaryl group comprises at least 1 to 6 N atoms, preferably 1 to 3 N atoms, and more preferred 1 N atom; and/or
- the heteroaryl group of the substituted heteroaryl group is a six-membered ring, comprising 1, 2 or 3 hetero atoms, wherein preferably the hetero atom is N.

According to one embodiment, wherein R¹ and R³ are selected from a substituted C₂ to C₂₄ heteroaryl group, wherein
- the substituted heteroaryl group comprises at least one six-membered ring; and/or
- the substituted heteroaryl group comprises at least 1 to 6 N atoms, preferably 1 to 3 N atoms, and more preferred 1 N atom; and/or
- the heteroaryl group of the substituted heteroaryl group is a six-membered ring, comprising 1, 2 or 3 hetero atoms, wherein preferably the hetero atom is N.

According to one embodiment, wherein R¹ and R³ are independently selected from substituted C₆ to C₂₄ aryl, and substituted C₂ to C₂₄ heteroaryl group, wherein the at least one substituent is selected from halogen, F, CN, CF₃, C₂F₅.

According to one embodiment, wherein at least one R¹ and/or R³ is selected from a substituted C₂ to C₂₄ heteroaryl group, wherein
- the substituted heteroaryl group comprises at least one six-membered ring; and/or
- the substituted heteroaryl group comprises at least 1 to 3 N atoms, preferably 1 to 2 N atoms, also preferred 1 N atom; and/or
- the heteroaryl group of the substituted heteroaryl group is a six-membered ring, comprise 1, 2 or 3 hetero atoms, wherein preferably the hetero atom is N.

According to one embodiment, wherein at least one R¹ and/or R³ is selected from a substituted C₂ to C₂₄ heteroaryl group, wherein the heteroaryl group is selected from pyridyl, pyrimidinyl pyrazinyl, or triazinyl.

According to one embodiment, wherein at least one R¹ or R³, or R¹ and R³ are selected from a substituted C₂ to C₂₄ heteroaryl group, wherein the C₂ to C₂₄ heteroaryl group is selected from pyridyl, pyrimidinyl, pyrazinyl, triazinyl.

According to one embodiment, wherein at least one R¹ and/or R³ is selected from a substituted C₂ to C₂₄ heteroaryl group, wherein the at least one substituent of the substituted heteroaryl group is selected from the group comprising halogen, F, Cl, CN, partially or fully fluorinated C₁ to C₆ alkyl, partially or fully fluorinated C₁ to C₆ alkoxy; preferably from the group comprising halogen, F, Cl, CN, partially or fully fluorinated C₁ to C₆ alkyl, urther preferred from the group comprising halogen, F, Cl, CN, partially or fully fluorinated C₁ to C₄ alkyl; and more preferred from the group comprising F, CN, partially or fully fluorinated C₁ to C₆ alkyl; also preferred F, CN, partially or fully fluorinated C₁ to C₆ alkyl, also preferred halogen, F, Cl, CN, partially or fully fluorinated C₁ to C₄ alkyl; and more preferred from the group comprising at least one CN, at least one CF₃ group, and/or at least two F atoms.

According to one embodiment, wherein at least one R¹ or R³, or R¹ and R³ are selected from a substituted C₂ to C₂₄ heteroaryl group, wherein at least one substituent is selected from halogen, F, Cl, CN, partially or fully fluorinated C₁ to C₆ alkyl, partially or fully fluorinated C₁ to C₆ alkoxy., and one R¹, R² or R³ is selected from substituted or unsubstituted C₁ to C₁₂ alkyl or substituted or unsubstituted C₁ to C₁₂ alkoxy,
wherein the at least one substituent is selected from halogen, F, Cl, CN, substituted or unsubstituted C₁ to C₆ alkyl, partially or fully fluorinated C₁ to C₆ alkyl, substituted or unsubstituted C₁ to C₆ alkoxy, partially or fully fluorinated C₁ to C₆ alkoxy; and one R¹, R² or R³ is selected from H, D, substituted or unsubstituted C₁ to C₁₂ alkyl, substituted or unsubstituted C₁ to C₁₂ alkoxy, wherein the at least one substituent is selected from halogen, F, Cl, CN, substituted or unsubstituted C₁ to C₆ alkyl, partially or fully fluorinated C₁ to C₆ alkyl, substituted or unsubstituted C₁ to C₆ alkoxy, partially or fully fluorinated C₁ to C₆ alkoxy; wherein
the substituents are selected from halogen, F, Cl, CN, C₁ to C₆ alkyl, CF₃, OCH₃ and OCF₃.

According to one embodiment, wherein one R¹ is selected from a substituted C₂ to C₂₄ heteroaryl group, wherein at least one, two or three substituents are selected from CF₃ group.

According to one embodiment, wherein R³ is selected from a substituted C₂ to C₂₄ heteroaryl group, wherein at least one, two or three substituents are selected from CF₃ group and/or CN group.

According to one embodiment, wherein R¹ is selected from a substituted C₆ to C₂₄ aryl group, wherein at least one, two or three substituents are selected from CF₃ group.

According to one embodiment, wherein R³ is selected from a substituted C₆ to C₂₄ aryl group, wherein at least one, two or three substituents are selected from CF₃ group and/or CN group.

According to one embodiment, wherein R¹ is selected from a substituted pyridin group, wherein at least one, two or three substituents are selected from CF₃ group.

According to one embodiment, wherein R³ is selected from a substituted pyridin group, wherein at least one, two or three substituents are selected from CF₃ group and/or CN group.

According to one embodiment, wherein R¹ is selected from a substituted phenyl group, wherein at least one, two or three substituents are selected from CF₃ group.

According to one embodiment, wherein R³ is selected from a substituted phenyl group, wherein at least one, two or three substituents are selected from CF₃ group and/or CN group.

According to one embodiment, wherein R¹ is selected from a substituted phenyl group, wherein at least one, two or three substituents are selected from CF₃ group; and wherein R³ is selected from a substituted phenyl group, wherein at least one, two or three substituents are selected from CF₃ group and/or CN group.

According to one embodiment, wherein R¹, R², R³ may be not selected from a substituted or unsubstituted C₆ to C₂₄ aryl group or a substituted or unsubstituted C₆ to C₁₈ aryl group.

According to one embodiment, wherein R¹ and R³ may be not selected from a unsubstituted aryl and/or unsubstituted heteroaryl group.

According to one embodiment, wherein Formula I may not comprise an unsubstituted aryl and/or unsubstituted heteroaryl group.

According to one embodiment, wherein Formula I may not comprises a substituted aryl group.

According to one embodiment, wherein Formula I may not comprises a substituted heteroaryl group.

According to one embodiment, wherein a substituted or unsubstituted C₆ to C₂₄ aryl group and/or a substituted or unsubstituted C₂ to C₂₄ heteroaryl group of R¹ and/or R³ is selected from the following Formulas D1 to D71: 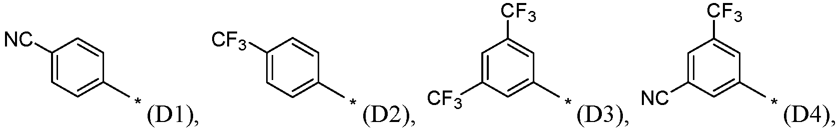 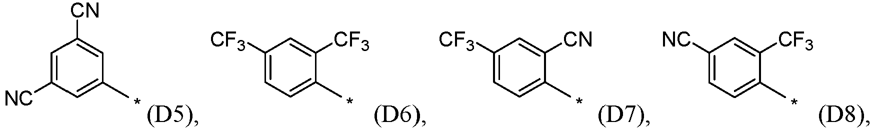 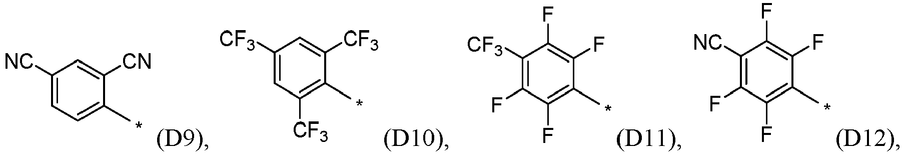 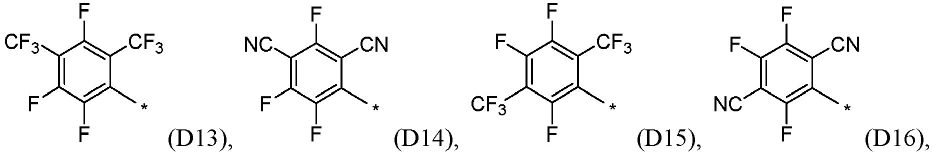 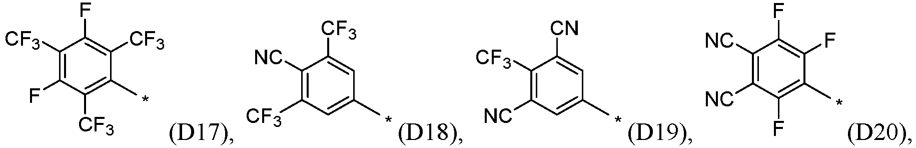 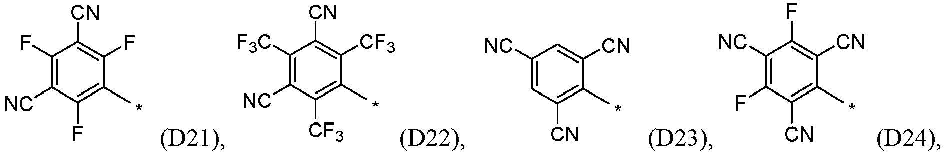 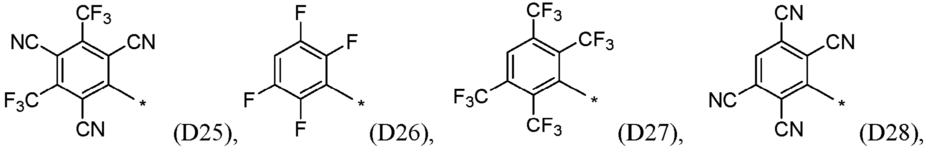 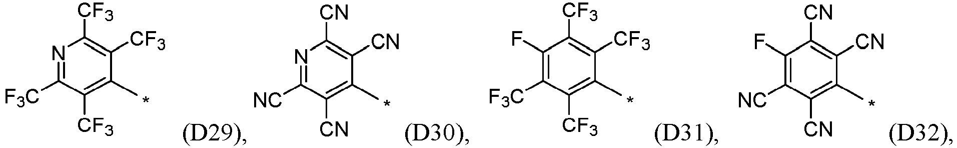 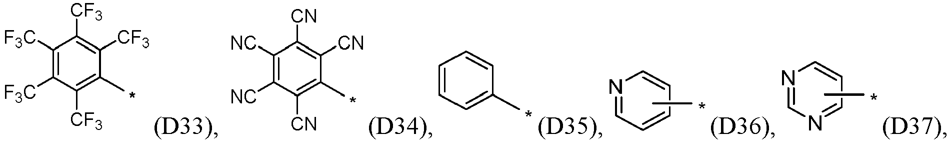 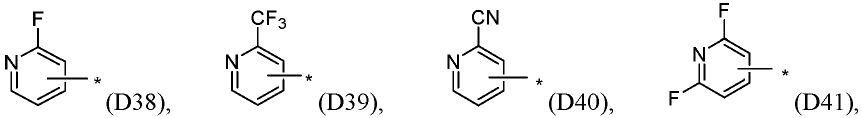 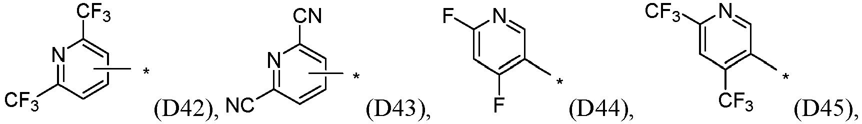 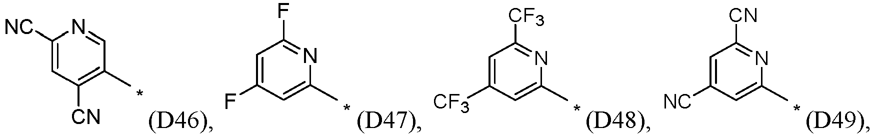 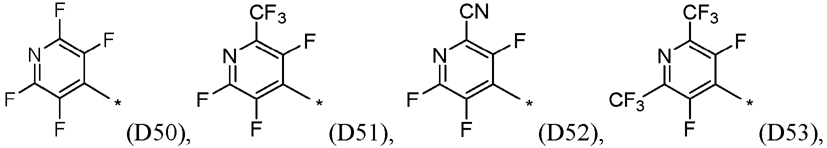 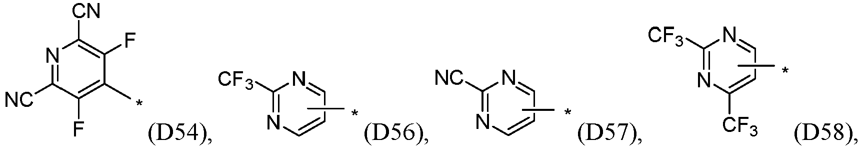 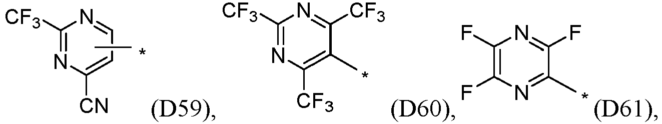 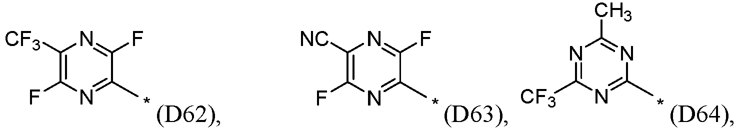 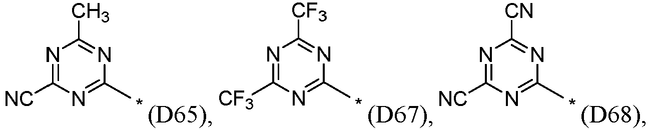 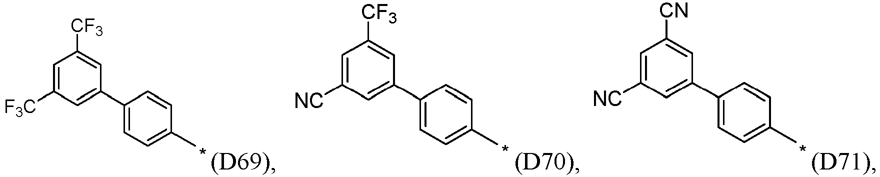 wherein the "*" denotes the binding position.

According to one embodiment of the present invention, at least at least one substituted or unsubstituted C₆ to C₂₄ aryl or substituted or unsubstituted C₂ to C₂₄ heteroaryl of R¹ and/or R³ is selected from the above formulae D1 to D34 and/or D38 to D71; preferably D3 to D34 and/or D39 to D71.

According to one embodiment of the present invention, R¹ is selected from formula D1 to D34 and/or D38 to D71, R² is selected from CN, C₁ to C₄ alkyl, partially or perfluorinated C₁ to C₄ alkyl, and R³ is selected from substituted or unsubstituted C₁ to C₁₂ alkyl, substituted or unsubstituted C₆ to C₂₄ aryl, and substituted or unsubstituted C₂ to C₂₄ heteroaryl group.

According to one embodiment, wherein the metal complex is represented by Formula I and is selected from the following Formulas E1 to E20: 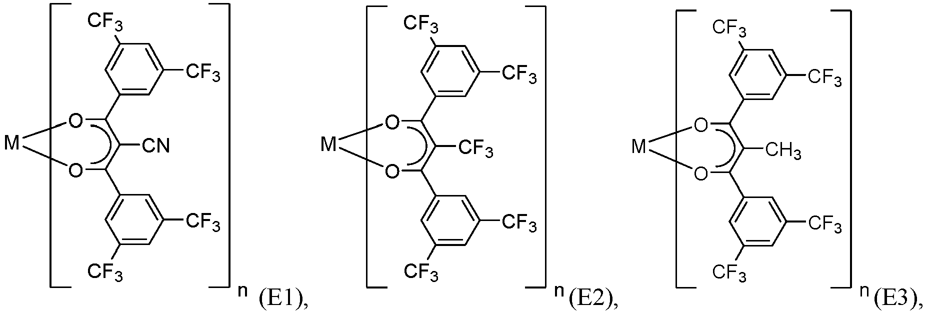 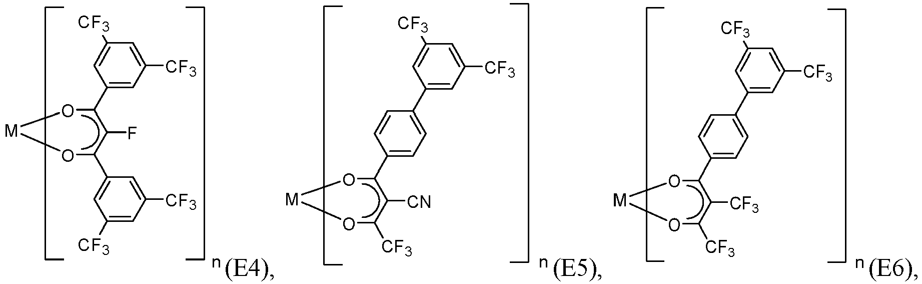 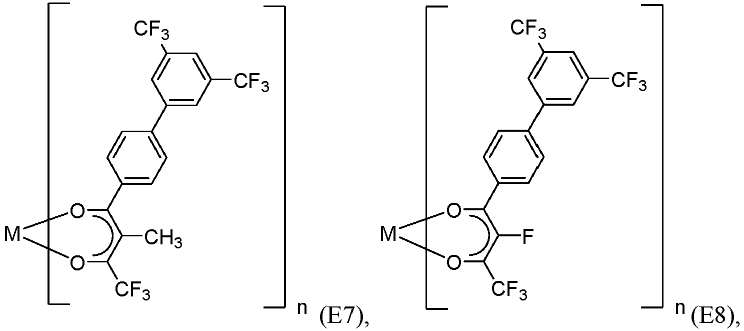 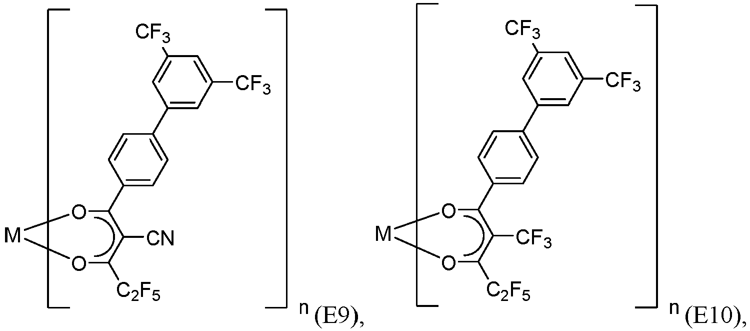 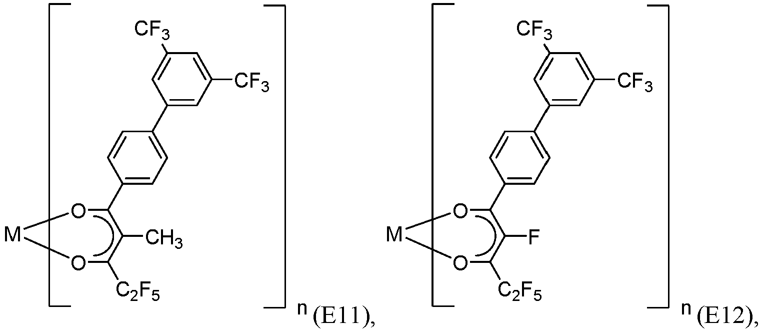 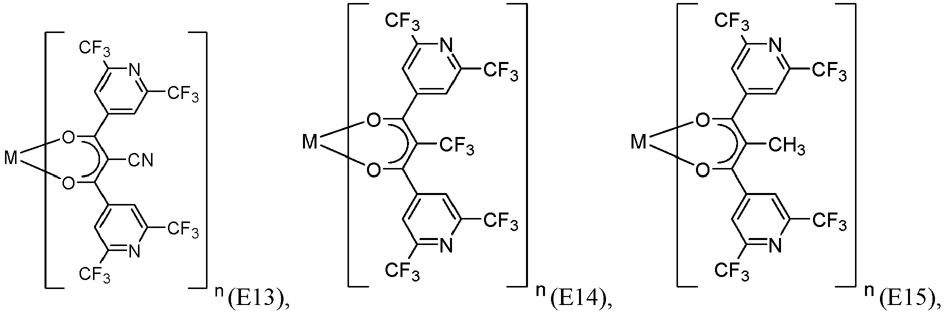 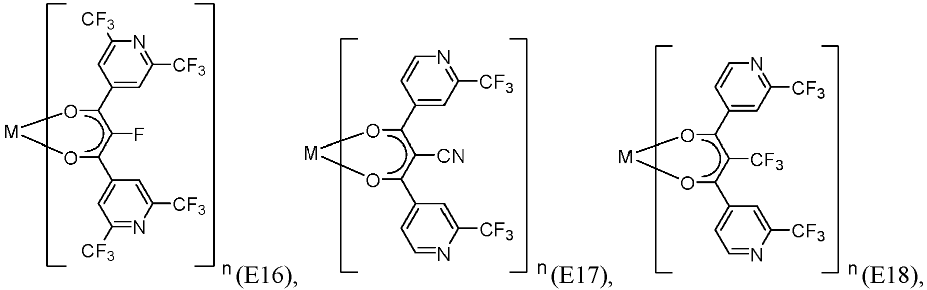 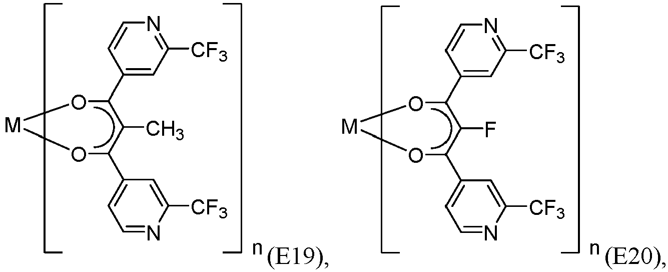 and more preferred wherein M is Cu(II) or Fe(III).

According to one embodiment, wherein the metal complex represented by Formula I is selected from Formulas E1 to E3, E5 to E7, E9 to E11, E13 to E15, and/or E17 to E19.

According to one embodiment, wherein the the metal complex is represented by Formula I and is selected from the following Formulas G1 to G7:

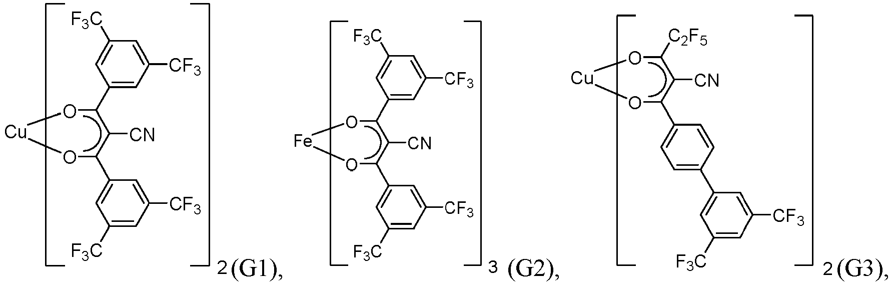

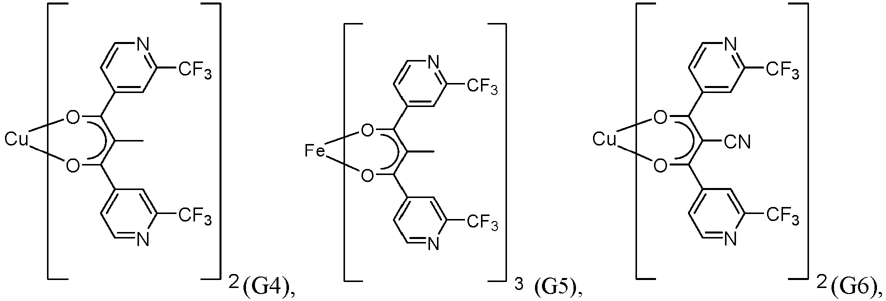

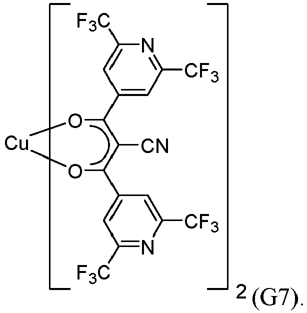

According to one embodiment, wherein the metal complex is represented by Formula I and is selected preferably from the Formulas G1 to G3 and/or G6 to G7.

The metal complex of formula (I) and the hole injection layer comprising a metal complex of formula (I) may be essentially non-emissive or non-emissive.

The concentration of the metal complex of formula (I) may be selected from 1 to 30 wt.-%, more preferably from 5 wt.-% to 25 wt.-%.

The concentration of the metal complex of formula (I) may be selected from 1 to 30 vol.-%, more preferably from 5 vol.-% to 25 vol.-%.

### Substantially covalent matrix compound

The covalent matrix compound, preferably substantially covalent matrix compound, also named matrix compound, may be an organic aromatic matrix compounds, which comprises organic aromatic covalent bonded carbon atoms. The substantially covalent matrix compound may be an organic compound, consisting substantially from covalently bound C, H, O, N, S, which may optionally comprise also covalently bound B, P or Si. The substantially covalent matrix compound may be an organic aromatic covalent bonded compound, which is free of metal atoms, and the majority of its skeletal atoms may be selected from C, O, S, N and preferably from C, O and N, wherein the majority of atoms are C-atoms. Alternatively, the covalent matrix compound is free of metal atoms and majority of its skeletal atoms may be selected from C and N, preferably the covalent matrix compound is free of metal atoms and majority of its skeletal atoms may be selected from C and the minority of its skeletal atoms may be N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

In one embodiment, the HOMO level of the substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) when determined under the same conditions.

In one embodiment of the present invention, the substantially covalent matrix compound may be free of alkoxy groups.

Preferably, the substantially covalent matrix compound comprises at least one arylamine moiety, alternatively a diarylamine moiety, alternatively a triarylamine moiety.

Preferably, the substantially covalent matrix compound is free of TPD or NPB.

Preferably, the matrix compound of the hole injection layer is free of metals and/or ionic bonds.

### Hole transport layer / Hole injection layer

According to a further embodiment the organic electronic device further comprises a hole transport layer, wherein the hole transport layer is arranged between the hole injection layer and the at least one emission layer.

In one embodiment of the present invention, the hole injection layer comprises a substantially covalent matrix compound.

In one embodiment of the present invention, the hole transport layer comprises a substantially covalent matrix compound.

In one embodiment of the present invention, the hole transport layer comprises a substantially covalent matrix compound, wherein the substantially covalent matrix compound in the hole injection layer and hole transport layer are selected the same.

### Compound of formula (III) or a compound of formula (IV)

According to the present invention, the substantially covalent matrix compound, also referred to as matrix compound herein, may comprises at least one arylamine compound, diarylamine compound, triarylamine compound, a compound of formula (III) or a compound of formula (IV): 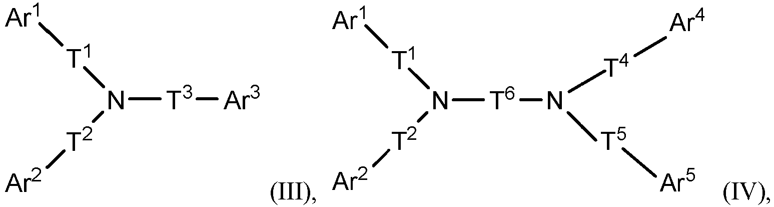 wherein:
- T¹, T², T³, T⁴ and T⁵: are independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³, Ar⁴ and Ar⁵ are selected the same or different from the group comprising H, D, F, C(-O)R², CN, Si(R²)₃, P(-O)(R²)₂, OR², S(-O)R², S(-O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

According to an embodiment of the electronic device, wherein the substantially covalent matrix compound comprises a compound of formula (III) or formula (IV): 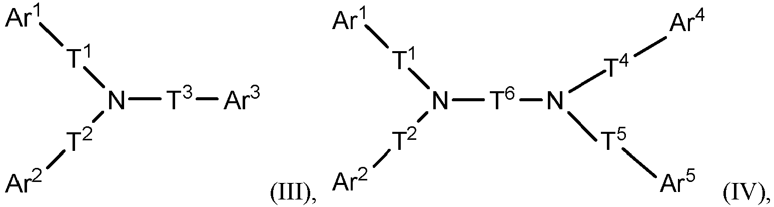 wherein
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents of Ar¹, Ar², Ar³, Ar⁴ and Ar⁵ are selected the same or different from the group comprising H, straight-chain alkyl having 1 to 20 carbon atoms, branched alkyl having 1 to 20 carbon atoms, cyclic alkyl having 3 to 20 carbon atoms, alkenyl or alkynyl groups having 2 to 20 carbon atoms, alkoxy groups having 1 to 20 carbon atoms, C₆ to C₁₈ aryl, C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

Preferably, the substituents of Ar¹, Ar², Ar³, Ar⁴ and Ar⁵ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, alkoxy groups having 1 to 6 carbon atoms, C₆ to C₁₈ aryl, C₃ to C₁₈ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl. Thereby, the compound of formula (III) or (IV) may have a rate onset temperature suitable for mass production.

According to an embodiment of the electronic device, wherein the substantially covalent matrix compound comprises a compound of formula (III) or formula (IV): 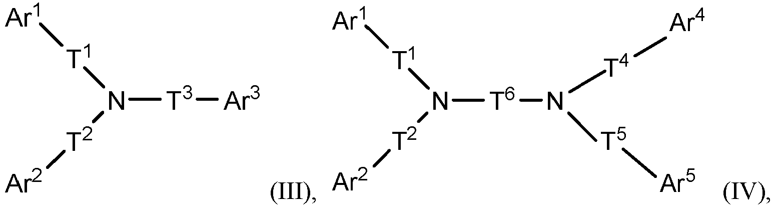 wherein
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle.

According to an embodiment of the electronic device, wherein the substantially covalent matrix compound comprises a compound of formula (III) or formula (IV): 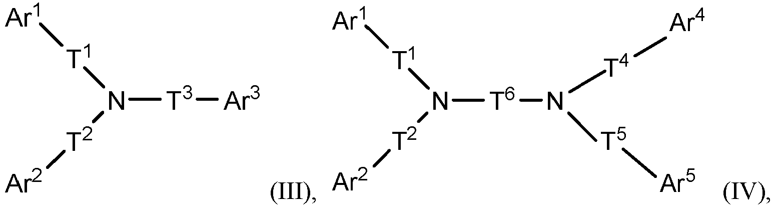 wherein
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene].

Thereby, the compound of formula (III) or (IV) may have a rate onset temperature suitable for mass production.

According to an embodiment wherein T¹, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from B1 to B16: 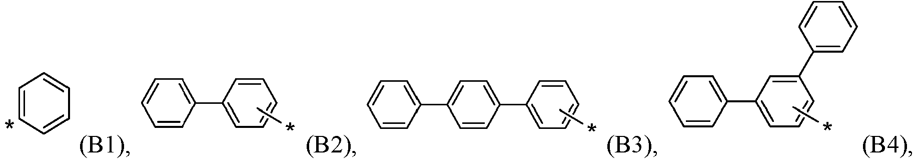 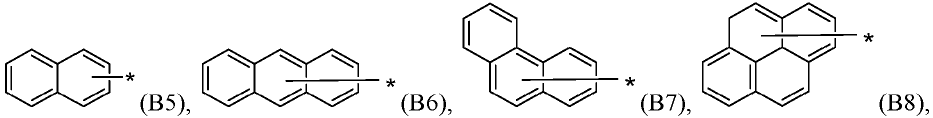 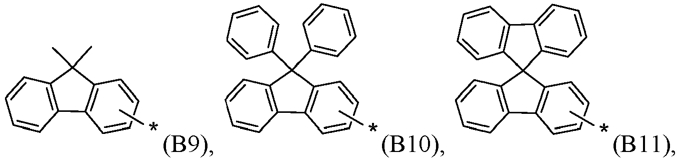 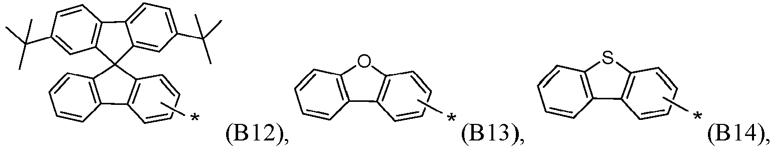 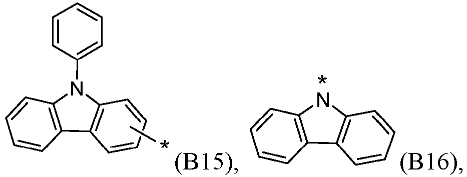 wherein the asterix "*" denotes the binding position.

According to an embodiment, wherein Ar¹, Ar², Ar³, Ar⁴ and Ar⁵ may be independently selected from B1 to B 15; alternatively selected from B1 to B10 and B13 to B 15.

According to an embodiment, wherein Ar¹, Ar², Ar³, Ar⁴ and Ar⁵ may be independently selected from the group consisting of B1, B2, B5, B7, B9, B10, B13 to B16.

The rate onset temperature may be in a range particularly suited to mass production, when Ar¹, Ar², Ar³, Ar⁴ and Ar⁵ are selected in this range.

The "matrix compound of formula (III) or formula (IV) " may be also referred to as "hole transport compound".

According to one embodiment the compound of formula (III) or formula (IV) may comprises at least ≥ 1 to ≤ 6 substituted or unsubstituted aromatic fused ring systems comprising heteroaromatic rings.

According to one embodiment the compound of formula (III) or formula (IV) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the compound of formula (III) or formula (IV) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the compound of formula (III) or formula (IV) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems.

According to one embodiment the compound of formula (III) or formula (IV) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings.

According to one embodiment the compound of formula (III) or formula (IV) may comprises at least ≥ 1 to ≤ 3 or 2 substituted or unsubstituted unsaturated 5- to 7-member ring of a heterocycle.

According to one embodiment the compound of formula (III) or formula (IV) may comprises at least ≥ 1 to ≤ 3 or 2 substituted or unsubstituted unsaturated 7-member ring of a heterocycle.

According to one embodiment substituted or unsubstituted aromatic fused ring systems of the compound of formula (III) or formula (IV) may comprises at least ≥ 1 to ≤ 3 or 2 substituted or unsubstituted unsaturated 5- to 7-member ring of a heterocycle.

According to one embodiment the substituted or unsubstituted aromatic fused ring systems of the matrix compound of formula (III) or formula (IV) may comprises at least ≥ 1 to ≤ 3 or 2 substituted or unsubstituted unsaturated 7-member ring of a heterocycle.

According to one embodiment the compound of formula (III) or formula (IV) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises substituted or unsubstituted unsaturated 5- to 7-member ring of a heterocycle.

According to one embodiment the compound of formula (III) or formula (IV) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises substituted or unsubstituted unsaturated 5- to 7-member ring of a heterocycle.

According to one embodiment the compound of formula (III) or formula (IV) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises at least ≥ 1 to ≤ 3 or 2 substituted or unsubstituted unsaturated 5- to 7-member ring of a heterocycle.

According to one embodiment the compound of formula (III) or formula (IV) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises at least ≥ 1 to ≤ 3 or 2 substituted or unsubstituted unsaturated 5- to 7-member ring of a heterocycle.

According to one embodiment the compound of formula (III) or formula (IV) may comprises:
- a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment the compound of formula (III) or formula (IV) may comprises at least at least ≥ 1 to ≤ 6, preferably ≥ 2 to ≤ 5, or further preferred 3 or 4 of the substituted or unsubstituted aromatic fused ring systems with:
- at least one unsaturated 5-member ring, and/or
- at least one unsaturated 6-member ring, and/or
- at least one unsaturated 7-member ring; wherein preferably at least one unsaturated 5- and/or at least one unsaturated 7-member ring comprises at least 1 to 3, preferably 1 hetero-atom.

According to one embodiment the compound of formula (III) or formula (IV) may comprises at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system comprises at least ≥ 1 to ≤ 3 or 2 substituted or unsubstituted unsaturated 5- to 7-member ring of a heterocycle.

According to one embodiment the compound of formula (III) or formula (IV) may comprises :
- at least ≥ 6 to ≤ 12, preferably ≥ 7 to ≤ 11, further preferred ≥ 8 to ≤ 10 or 9 aromatic rings; and/or
- at least ≥ 4 to ≤ 11, preferably ≥ 5 to ≤ 10, further preferred ≥ 6 to ≤ 9 or in addition preferred 7 or 8 non-hetero aromatic rings, preferably the non-hetero aromatic rings are aromatic C₆ rings; and/or
- at least ≥ 1 to ≤ 4, preferably 2 or 3 aromatic 5-member-rings, preferably hetero aromatic 5-member-rings; and/or
- at least 1 or 2 unsaturated 5- to 7-member-ring of a heterocycle, preferably at least 1 or 2 unsaturated 7-member-ring of a heterocycle;
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and/or
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and
      the hole transport compound or the hole transport compound according to formula I comprises at least ≥ 1 to ≤ 4, preferably 2 or 3 aromatic 5-member-rings, preferably hetero aromatic 5-member-rings, and/or
      the hole transport compound or the hole transport compound according to formula (I) comprises at least 1 or 2 unsaturated 5- to 7-member-ring of a heterocycle, preferably at least 1 or 2 unsaturated 7-member-ring of a heterocycle.

According to one embodiment the compound of formula (III) or formula (IV) may comprises a hetero-atom, which may be selected from the group comprising O, S, N, B or P, preferably the hetero-atom may be selected from the group comprising O, S or N.

According to one embodiment the matrix compound of formula (III) or formula (IV) may comprises at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system optional comprises at least ≥ 1 to ≤ 3 or 2 substituted or unsubstituted unsaturated 5- to 7-member ring of a heterocycle; and wherein the substituted or unsubstituted aromatic fused ring system comprises a hetero-atom, which may be selected from the group comprising O, S, N, B, P or Si, preferably the hetero-atom may be selected from the group comprising O, S or N.

According to one embodiment the compound of formula (III) or formula (IV) may be free of hetero-atoms which are not part of an aromatic ring and/or part of an unsaturated 7-member-ring, preferably the hole transport compound or the hole transport compound according to formula (I) may be free on N-atoms except N-atoms which are part of an aromatic ring or are part of an unsaturated 7-member-ring.

According to one embodiment, the substantially covalent matrix compound comprises at least one naphthyl group, carbazole group, dibenzofurane group, dibenzothiophene group and/or substituted fluorenyl group, wherein the substituents are independently selected from methyl, phenyl or fluorenyl.

According to an embodiment of the electronic device, wherein the compound of formula (III) or formula (IV) are selected from K1 to K17:

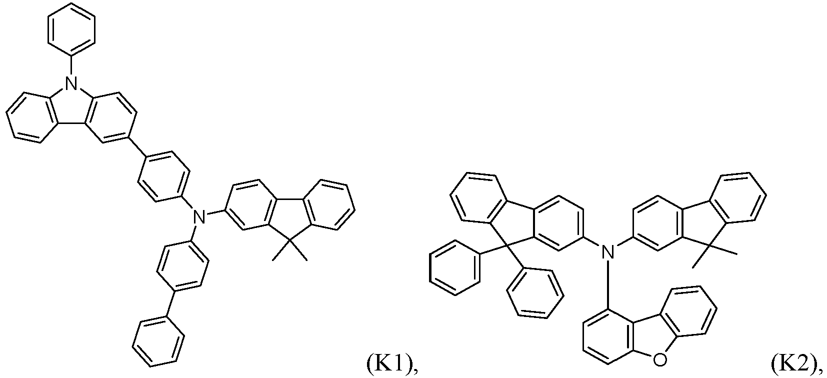

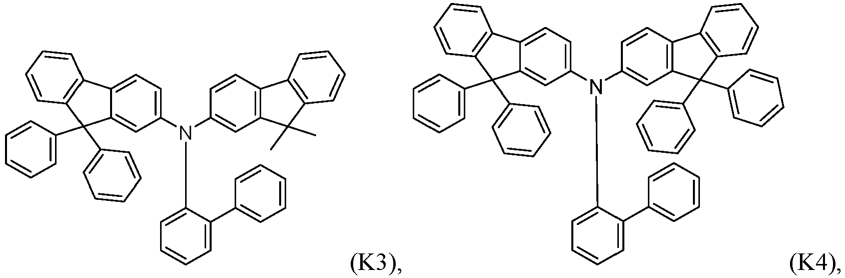

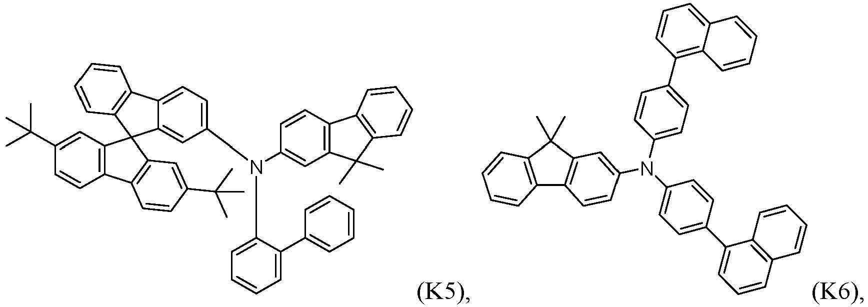

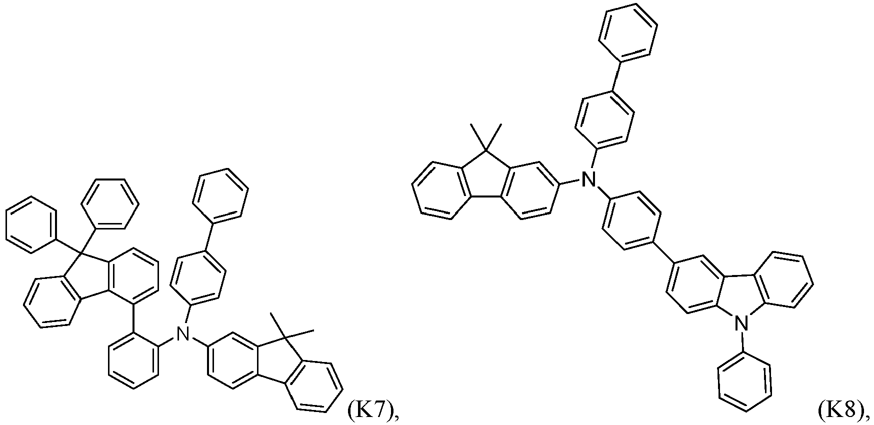

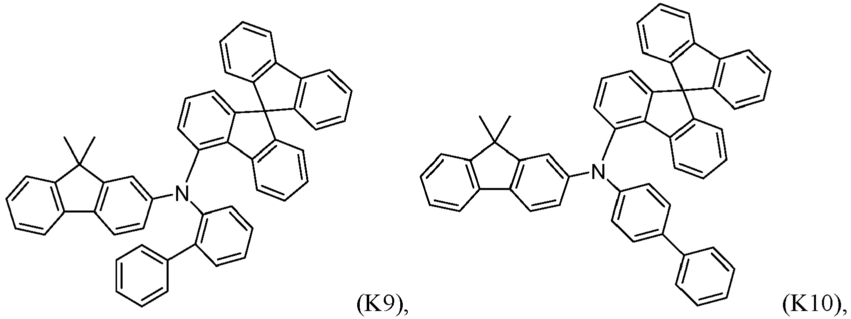

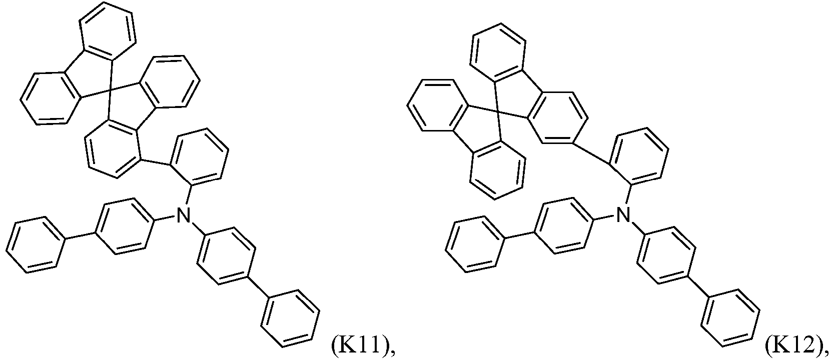

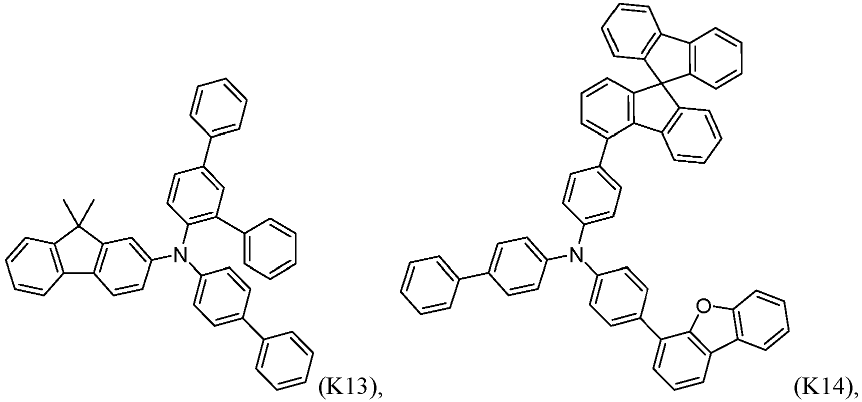

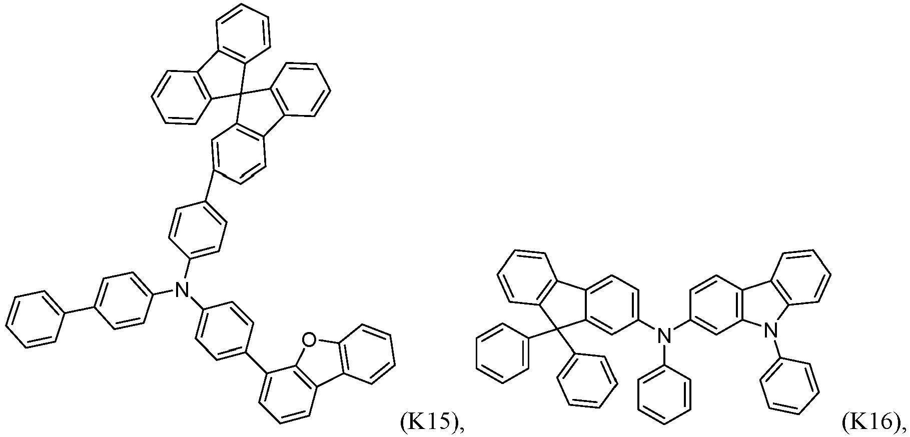

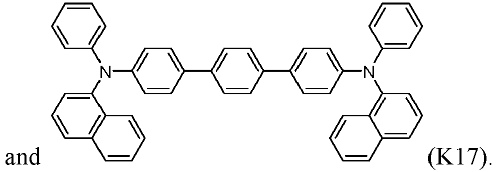

The substantially covalent matrix compound may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

### Hole injection layer

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the hole transport compound that is used to form the HIL, and the desired structure and thermal properties of the HIL. In general, however, conditions for vacuum deposition may include a deposition temperature of 100° C to 350° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the hole transport compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of a metal complex according to formula (I).

The thickness of the HIL may be in the range from about 1 nm to about 15 nm, and for example, from about 2 nm to about 15 nm, alternatively about 2 nm to about 12 nm.

When the thickness of the HIL is within this range, the HIL may have excellent hole injecting characteristics, without a substantial penalty in driving voltage.

According to one embodiment of the present invention, the hole injection layer may comprise:
- at least about ≥ 0.5 wt.-% to about ≤ 30 wt.-%, preferably about ≥ 0.5 wt.-% to about ≤ 20 wt.-%, and more preferred about ≥ 15 wt.-% to about ≤ 1 wt.-% of a metal complex according to formula (I), and
- at least about ≥ 70 wt.-% to about ≤ 99.5 wt.-%, preferably about ≥ 80 wt.-% to about ≤ 99.5 wt.-%, and more preferred about ≥ 85 wt.-% to about ≤ 99 wt.-% of a substantially covalent matrix compound; preferably the wt.-% of the a metal complex according to formula (I) is lower than the wt.-% of the substantially covalent matrix compound ; wherein the weight-% of the components are based on the total weight of the hole injection layer.

Preferably, the hole injection layer may be free of ionic liquids, metal phthalocyanine, CuPc, HAT-CN, Pyrazino[2,3-f][1,10]phenanthroline-2,3-dicarbonitrile, F₄TCNQ, metal fluoride and/or metal oxides, wherein the metal in the metal oxide is selected from Re and/or Mo. Thereby, the hole injection layer may be deposited under conditions suitable for mass production.

According to an embodiment of the electronic device, wherein the hole injection layer is non-emissive.

It is to be understood that the hole injection layer is not part of the anode layer.

### First anode sub-layer

According to one embodiment, the first metal of the first anode sub-layer may have a work function in the range of ≥ 4.2 and ≤ 6 eV. The first metal may be selected from a metal or a metal alloy.

According to one embodiment, wherein the first metal of the first anode sub-layer may be selected from the group comprising Ag, Mg, Al, Cr, Pt, Au, Pd, Ni, Nd, Ir, preferably Ag, Au or Al, and more preferred Ag.

The first anode sub-layer may have a thickness in the range of 5 to 200 nm, alternatively 8 to 180 nm, alternatively 8 to 150 nm, alternatively 100 to 150 nm.

The first anode sub-layer may formed by depositing the first metal via vacuum thermal evaporation.

It is to be understood that the first anode layer is not part of the substrate.

### Second anode sub-layer

According to one embodiment, the transparent conductive oxide may be selected from the group comprising indium tin oxide (ITO) or indium zinc oxide (IZO), more preferred indium tin oxide (ITO). preferably ITO or IZO.

The first anode sub-layer may have a thickness in the range of 3 to 200 nm, alternatively 3 to 180 nm, alternatively 3 to 150 nm, alternatively 3 to 20 nm.

The second anode sub-layer may be formed by sputtering of the transparent conductive oxide.

### Third anode sub-layer

According to one embodiment the anode layer of the organic electronic device may comprises at least three anode sub-layers of a first anode sub-layer, a second anode sub-layer and third anode sub-layer. According to one embodiment the anode layer of the organic electronic device may comprises in addition to the first and second anode sub-layers a third anode sub-layer, wherein the third anode sub-layer comprises a transparent conductive oxide, wherein the third anode sub-layer may be arranged between the substrate and the first anode sub-layer.

The third anode sub-layer may have a thickness in the range of 3 to 200 nm, alternatively 3 to 180 nm, alternatively 3 to 150 nm, alternatively 3 to 20 nm.

The third anode sub-layer may be formed by sputtering of the transparent conductive oxide.

It is to be understood that the third anode layer is not part of the substrate.

### Anode layer

According to one embodiment, the anode layer may comprise a first anode sub-layer comprising or consisting of Ag or Au, a second anode-sub-layer comprising or consisting of ITO or IZO and optionally a third anode sub-layer comprising or consisting of ITO or IZO. Preferably the first anode sub-layer may comprises or consists of Ag, the second anode-sublayer may comprises or consists of ITO and the third anode sub-layer may comprises or consists of ITO. Preferably, the transparent conductive oxide in the second and third anode sub-layer may be selected the same.

According to one embodiment, the anode layer may comprise a first anode sub-layer comprising Ag or Au having a thickness of 100 to 150 nm, a second anode-sub-layer comprising ITO or IZO having a thickness of 3 to 20 nm and a third anode sub-layer comprising ITO or IZO having a thickness of 3 to 20 nm.

### Electronic device

According to another embodiment the electronic device comprises a substrate, an anode layer free of sub-layers or an anode layer which may comprise two or more sub-layers, a cathode layer and a hole injection layer, wherein the hole injection layer comprises a metal complex according to formula (I).

The electronic device may comprise at least one photoactive layer. The at least one photoactive layer may be an emission layer or a light-absorption layer, preferably an emission layer.

According to another embodiment, the electronic device may have the following layer structure, wherein the layers having the following order:
an anode layer, a hole injection layer comprising a substantially covalent matrix compound and a metal complex according to formula (I), a hole transport layer, optional an electron blocking layer, at least a first emission layer, optional a hole blocking layer, an electron transport layer, optional an electron injection layer, and a cathode layer.

According to another aspect, it is provided an organic electronic device comprising at least one organic light emitting device according to any embodiment described throughout this application, preferably, the organic electronic device comprises the organic light emitting diode in one of embodiments described throughout this application. More preferably, the organic electronic device is a display device.

According to one embodiment of the present invention, wherein the electronic device may comprise an semiconductor layer comprising a metal complex according to formula (I) and a substantially covalent matrix compound comprising at least one arylamine compound, diarylamine compound, triarylamine compound, wherein in formula (I) M is selected from Li(I), Na(I), K(I), Cs(I), Mg(II), Ca(II), Sr(II), Ba(II), Sc(III), Y(III), Ti(IV), V(III-V), Cr(III-VI), Mn(II), Mn(III), Fe(II), Fe(III), Co(II), Co(III), Ni(II), Cu(I), Cu(II), Zn(II), Ag(I), Au(I), Au(III), Al(III), Ga(III), In(III), Sn(II), Sn(IV), or Pb(II); preferably M is selected from Cu(II), Fe(III), Co(III), Mn(III), Ir(III), Bi(III); and more preferred M is selected from Fe(III) and Cu(II).

### Further layers

In accordance with the invention, the electronic device may comprise, besides the layers already mentioned above, further layers. Exemplary embodiments of respective layers are described in the following:

### Substrate

The substrate may be any substrate that is commonly used in manufacturing of electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a transistor backplane. Preferably, the substrate is a silicon substrate or transistor backplane.

### Hole transport layer

According to one embodiment of the electronic device, wherein the electronic device further comprises a hole transport layer, wherein the hole transport layer is arranged between the hole injection layer and the at least one first emission layer.

The hole transport layer may comprise a substantially covalent matrix compound. According to one embodiment the substantially covalent matrix compound of the hole transport layer may be selected from at least one organic compound. The substantially covalent matrix may consist substantially from covalently bound C, H, O, N, S, which optionally comprise in addition covalently bound B, P, As and/or Se.

According to one embodiment of the electronic device, the hole transport layer comprises a substantially covalent matrix compound, wherein the substantially covalent matrix compound of the hole transport layer may be selected from organic compounds consisting substantially from covalently bound C, H, O, N, S, which optionally comprise in addition covalently bound B, P, As and/or Se.

According to one embodiment, the substantially covalent matrix compound of the hole transport layer may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the substantially covalent matrix compound of the hole injection layer and the substantially covalent matrix compound of the hole transport layer are selected the same.

According to one embodiment of the electronic device, wherein the hole transport layer of the electronic device comprises a substantially covalent matrix compound, preferably the substantially covalent matrix compound in the hole injection layer and hole transport layer are selected the same.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the hole transport compound that is used to form the HTL.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 200 nm, further about 100 nm to about 180 nm, further about 110 nm to about 140 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer may be achieved. The triplet control layer may be selected from triarylamine compounds with a triplet level above the triplet level of the phosphorescent emitter in the adjacent emission layer.

The thickness of the electron blocking layer may be selected between 2 and 20 nm.

### Emission layer (EML)

The at least one first emission layer (EML), also referred to as first emission layer may be formed on the HTL or EBL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to the present invention it is preferred that the electronic device comprises one emission layer that is named "first emission layer". However, the electronic device optionally comprises two emission layers, wherein the first layer is named first emission layer and second layer is named second emission layer.

It may be provided that the at least one emission layer also referred to as first emission layer is free of the matrix compound of the hole injection layer.

It may be provided that the at least one emission layer does not comprise the a metal complex according to formula (I).

The at least one emission layer (EML) may be formed of a combination of a host and an emitter dopant. Example of the host are Alq3, 4,4'-N,N'-dicarbazole-biphenyl (HTC-10), poly(n-vinyl carbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters; however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)₂Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the at least one emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent emitter dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form an HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitate injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

### Method of manufacturing

According to another aspect, there is provided a method of manufacturing an electronic device, the method using:
- at least one deposition source, preferably two deposition sources and more preferred at least three deposition sources.

The methods for deposition that may be suitable comprise:
- deposition via vacuum thermal evaporation;
- deposition via solution processing, preferably the processing may be selected from spin-coating, printing, casting; and/or
- slot-die coating.

According to various embodiments, there is provided a method using:
- a first deposition source to release the matrix compound, and
- a second deposition source to release the a metal complex according to formula (I), also named metal complex.

The method comprising the steps of forming the hole injection layer; whereby for an electronic device:
- the hole injection layer is formed by releasing the matrix compound according to the invention from the first deposition source and the a metal complex according to formula (I), also named metal complex, from the second deposition source.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiment according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

### Figures 1 to 9

- FIG. 1: is a schematic sectional view of an organic electronic device, according to an exemplary embodiment of the present invention;
- FIG. 2: is a schematic sectional view of an organic electronic device, according to an exemplary embodiment of the present invention;
- FIG. 3: is a schematic sectional view of an organic electronic device, according to an exemplary embodiment of the present invention.
- FIG. 4: is a schematic sectional view of an organic electronic device, according to an exemplary embodiment of the present invention;
- FIG. 5: is a schematic sectional view of an organic electronic device, according to an exemplary embodiment of the present invention;
- FIG. 6: is a schematic sectional view of an organic electronic device, according to an exemplary embodiment of the present invention;
- FIG. 7: is a schematic sectional view of an organic electronic device, according to an exemplary embodiment of the present invention;
- FIG. 8: is a schematic sectional view of an organic electronic device, according to an exemplary embodiment of the present invention;
- FIG. 9: is a schematic sectional view of an organic electronic device, according to an exemplary embodiment of the present invention.

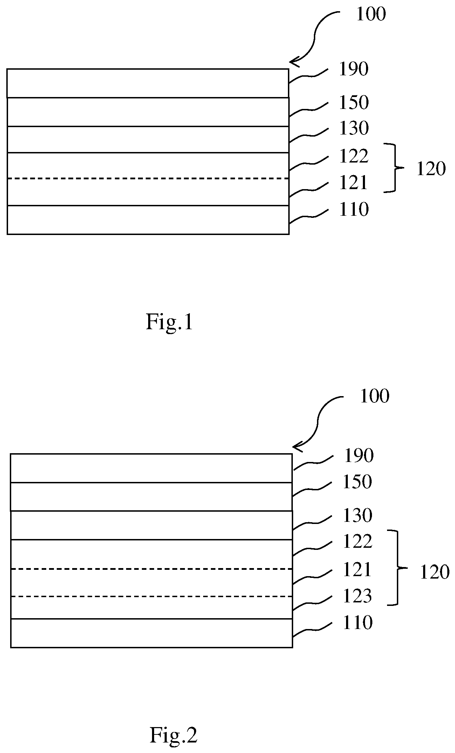

Hereinafter, the figures 1 to 9 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) is disposed on the anode layer (120). Onto the HIL (130), a first emission layer (EML) (150), and a cathode layer (190) are disposed.

FIG. 2 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120) comprising a first anode sub-layer (121), a second anode sub-layer (122) and a third anode sub-layer (123). Onto the HIL (130), a first emission layer (EML) (150), and a cathode layer (190) are disposed.

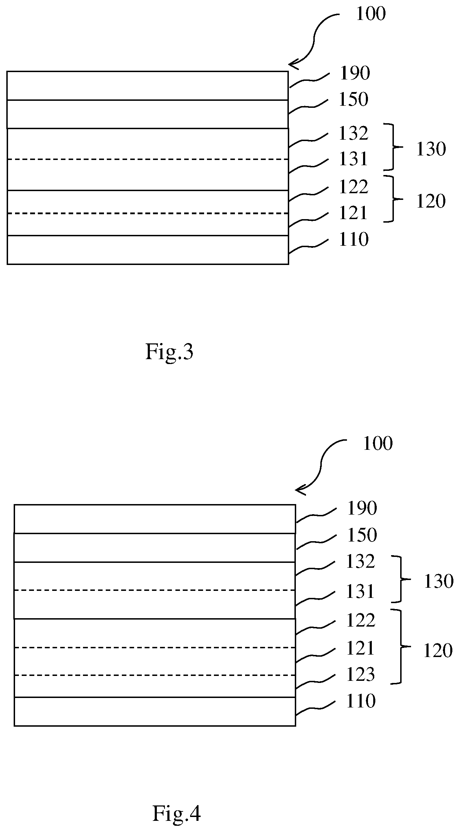

FIG. 3 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122), and a hole injection layer (HIL) (130) comprising a first hole injection sub-layer (131) and a second hole injection sub-layer (132). The HIL (130) comprising a first hole injection sub-layer (131) and a second hole injection sub-layer (132) is disposed on the anode layer (120). Onto the HIL (130), a first emission layer (EML) (150), and a cathode layer (190) are disposed.

FIG. 4 is a schematic sectional view of an organic electronic device (100), according to an exemplary embodiment of the present invention. The organic electronic device (100) includes a substrate (110), an anode layer (120) that comprises a first anode sub-layer (121) a second anode sub-layer (122) and a third anode sub-layer (123), and a hole injection layer (HIL) (130) comprising a first hole injection sub-layer (131) and a second hole injection sub-layer (132). The HIL (130) comprising a first hole injection sub-layer (131) and a second hole injection sub-layer (132) is disposed on the anode layer (120). Onto the HIL (130), a first emission layer (EML) (150), and a cathode layer (190) are disposed.

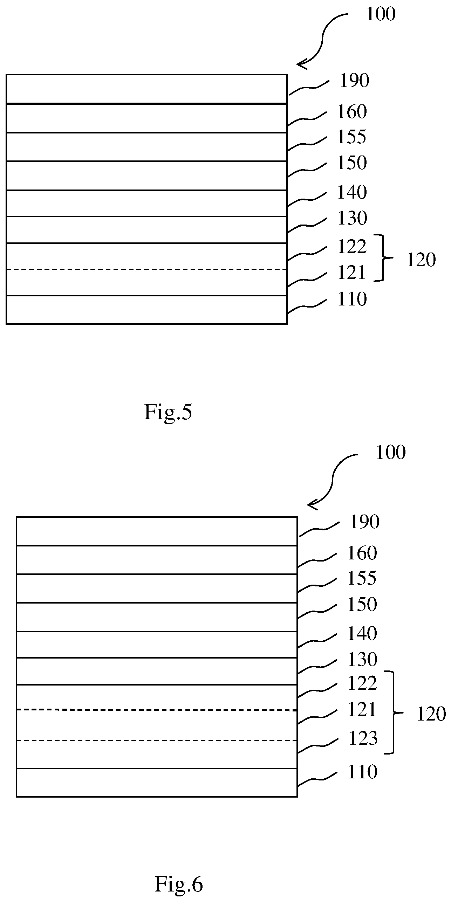

FIG. 5 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122), and a hole injection layer (HIL) (130). The HIL (130) is disposed on the anode layer (120). Onto the HIL (130), an hole transport layer (HTL) (140), a first emission layer (EML) (150), a hole blocking layer (BL) (155), an electron transport layer (ETL) (160), and a cathode layer (190) are disposed.

FIG. 6 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), an hole transport layer (HTL) (140), a first emission layer (EML) (150), a hole blocking layer (HBL) (155), an electron transport layer (ETL) (160), and a cathode layer (190) are disposed.

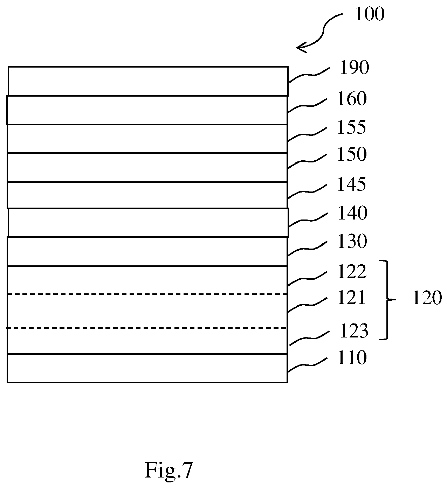

FIG. 7 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), and a cathode layer (190) are disposed.

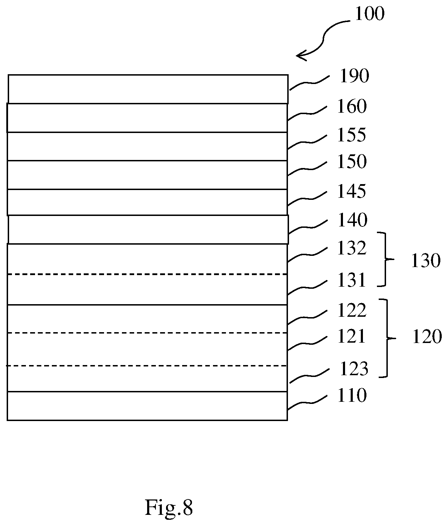

FIG. 8 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) comprises a first hole injection sub-layer (131) and a second hole injection sub-layer (132), wherein the first hole injection sub-layer (131) is disposed on the second anode sub-layer (122) and the second hole injection sub-layer (132) is disposed on the first hole injection sub-layer (131). Onto the HIL (130), a hole transport layer (HTL) (140), an electron blocking layer (EBL) (145), a first emission layer (EML) (150), a hole blocking layer (HBL) (155), an electron transport layer (ETL) (160), and a cathode layer (190) are disposed.

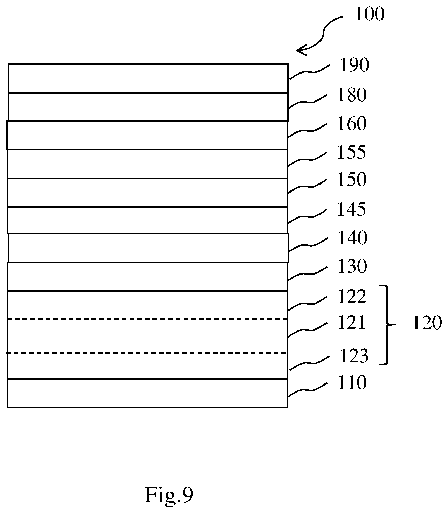

FIG. 9 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), an electron injection layer (EIL) (180) and a cathode layer (190) are disposed.

While not shown in Fig. 1 to Fig. 9, a capping and/or a sealing layer may further be formed on the cathode layer 190, in order to seal the organic electronic device 100. In addition, various other modifications may be applied thereto.

Hereinafter, the embodiments are illustrated in more detail with reference to examples. However, the present disclosure is not limited to the following examples.

### Detailed description

The invention is furthermore illustrated by the following examples which are illustrative only and non-binding.

### Metal complexes of formula (I)

Metal complexes of formula (I) may be prepared by known methods or as described below.

### Synthesis of 1,3-bis(3,5-bis(trifluoromethyl)phenyl)propane-1,3-dione

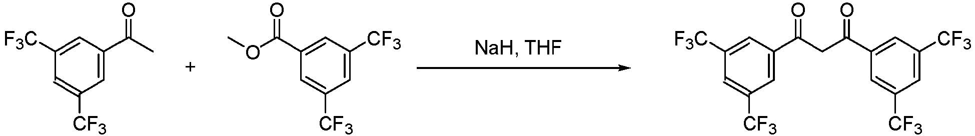

To a suspension of NaH (2.34g, 100 mmol) in 100 ml THF was added dropwise 1-(3,5-bis(trifluoromethyl)phenyl)ethan-1-one (10g, 39 mmol) and methyl 3,5-bis(trifluoromethyl)benzoate (11.7g, 43 mmol) dissolved together in 50 ml THF. The resulting mixture was refluxed for 30 h . The reaction mixture was cooled to RT and ice-cold 10% HCl (200 ml) was added during rapidly stirring. Et₂O was added (250 ml) and organic phase was separated, washed with water and dried over Na₂SO₄, concentrated. Crude product was triturated in hexane with traces of Et₂O for 3 h, filtered, washed with hexane and dried. Yield 13.4 g (69%).

### Synthesis of 2-(3,5-bis(trifluoromethyl)benzoyl)-3-(3,5-bis(trifluoromethyl)phenyl)-3-oxopropanenitrile

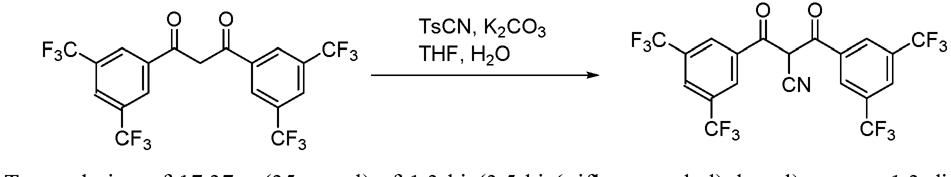

To a solution of 17.37 g (35 mmol) of 1,3-bis(3,5-bis(trifluoromethyl)phenyl)propane-1,3-dione and K₂CO₃ (7.26g, 52.5 mmol) in THF-water was added *p*-Tolylsulfonylcyanid (9.51g, 52.5 mmol) in one portion and the resulting mixture was stirred at RT for 3 h. The reaction mixture was cooled to 0°C, acidified with aq. 2M HCl, and extracted 2x500 ml of ethyl acetate. The combined organic phases were dried over MgSO4 and concentrated. Crude product was triturated in mixture of 100 ml hexane and 10 ml ethyl acetate for 1 h. Solid precipitate was filtered and washed with hexane. Filtrate was purified by chromatography on silica gel (DCM/Ethyl acetate/Hexane). Fractions with product were concentrated followed by acidic extraction (aq. 2M HCl/ethyl acetate). The combined organic phases were dried over MgSO4 and concentrated. Product was triturated in 20% Et₂O in hexane for 2 h, solid was filtered, washed with hexane, and dried. Yield 9.52 g (52%).

### Synthesis of bis(((Z)-1,3-bis(3,5-bis(trifluoromethyl)phenyl)-2-cyano-3-oxoprop-1-en-1-yl)oxy)copper (MC-1) / (G1)

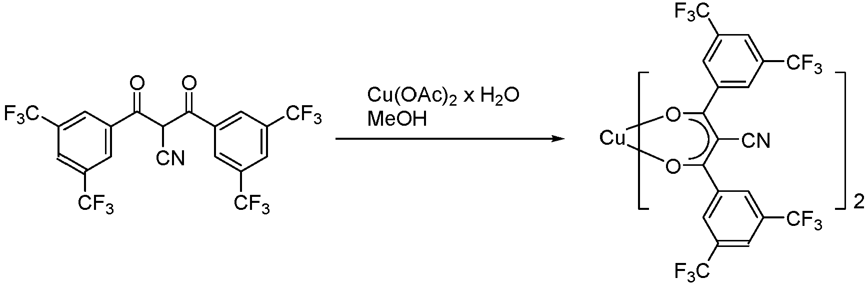

2.42g (4.64mmol) of 2-(3,5-bis(trifluoromethyl)benzoyl)-3-(3,5-bis(trifluoromethyl)phenyl)-3-oxopropanenitrile were dissolved in 40ml methanol and solution of 0.46g (2.32mmol) copper(II) acetate monohydrate in 30ml methanol and 20ml water was added. The mixture was stirred at room temperature overnight. The precipitate was filtered off, washed with water and dried in high vacuum. 2.29g (89%) product was obtained as a powder.

### Synthesis of 2-(3',5'-bis(trifluoromethyl)-[1,1'-biphenyl]-4-carbonyl)-4,4,5,5,5-pentafluoro-3-oxopentanenitrile

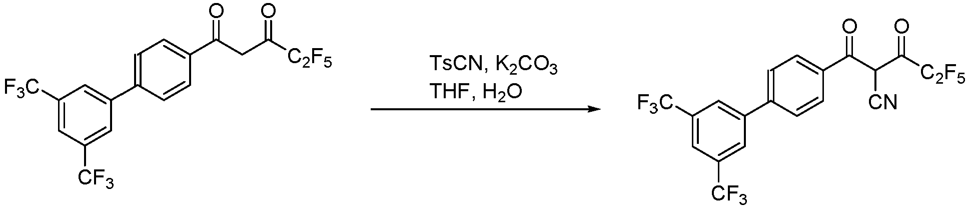

To a solution of 16.7 g (35 mmol) of 1-(3',5'-bis(trifluoromethyl)-[1,1'-biphenyl]-4-yl)-4,4,5,5,5-pentafluoropentane-1,3-dione and K₂CO₃ (7.26g, 52.5 mmol) in THF-water was added p-Tolylsulfonylcyanid (9.51g, 52.5 mmol) in one portion and the resulting mixture was stirred at RT for 20 h. THF was removed and 300 ml water and 300 ml DCM were added and stirred in ice/water bath for 30 min. White solid was filtered and washed with 2x300 ml water and 2x300 ml DCM and dried. Crude material was suspended in 100 ml DCM and 60 ml 1M HCl for 30 min, Layers were separated. Organic phase was washed with 30 ml of 1M HCl. Combined aq. phases were washed with 100 ml DCM. Combined organic phases were washed with 100 ml water, dried over MgSO₄ and concentrated at 40 °C. 100 ml hexane was added and stirred with 5 ml DCM in ice/water bath for 1 h. Solid was filtered, washed with cold hexane and dried. 14.27g (yield 81%).

### Synthesis of bis(((Z)-1-(3',5'-bis(trifluoromethyl)-[1,1'-biphenyl]-4-yl)-2-cyano-4,4,5,5,5-pentafluoro-3-oxopent-1-en-1-yl)oxy)copper (MC-2) / (G3)

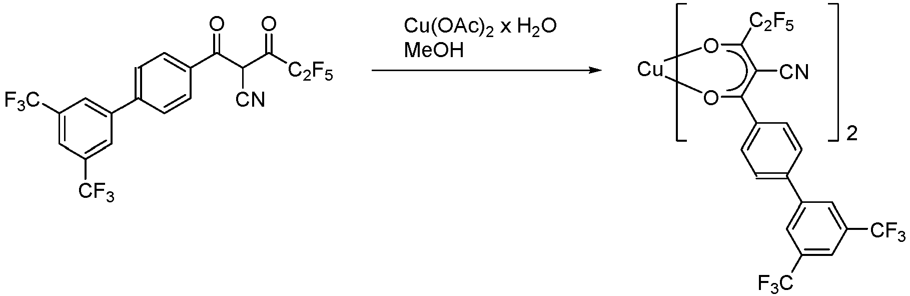

5.0g (9.94mmol) of 2-(3',5'-bis(trifluoromethyl)-[1,1'-biphenyl]-4-carbonyl)-4,4,5,5,5-pentafluoro-3-oxopentanenitrile were dissolved in 50ml methanol and 0.99g (4.97mmol) copper(II) acetate monohydrateand 20ml water were added. The mixture was stirred at room temperature overnight. The precipitate was filtered off, washed with water and dried in high vacuum. The crude product was crystallised from chloroform/ethyl acetate to obtain 3.60g (68%) product as a solid.

### Synthesis of N-methoxy-N-methyl-2-(trifluoromethyl)isonicotinamide

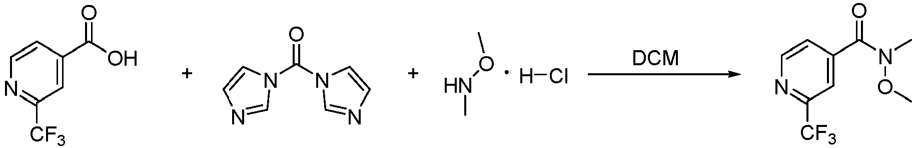

Flask was charged with 2-(trifluoromethyl)isonicotinic acid (20.1g, 100 mmol), dichloromethane (100 ml) and CDI (19.4g, 120 mmol) was added within 10 min. RM was stirred at r.t. for 1.5 h. Then, N,O-dimethylhydroxylamine hydrochloride (14.6g, 150mmol) was added and reaction mixture was stirred at r.t. for 17 h (overnight). Reaction was quenched with 1 M sol. of NaOH (50 mL) and extracted with dichloromethane (2x100 mL). Combined organic layers were washed with water, brine and solvent was evaporated in vacuo to give an oil (20.5 g, yield 87%).

### Synthesis of 1-(2-(trifluoromethyl)pyridin-4-yl)propan-1-one

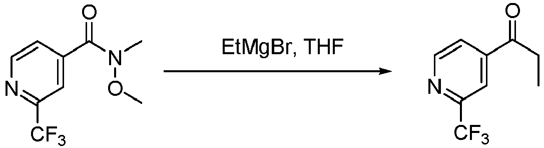

Flask was charged with N-methoxy-N-methyl-2-(trifluoromethyl)isonicotinamide (20.3g, 87 mmol), evacuated and filled with Ar. THF was added and RM was cooled to -79 °C. Then, EtMgBr (3M in THF, 130 mmol)) was added dropwise within 15 min. The reaction mixture was stirred at -79 °C for 1 h and then 0 °Cfor 2 h. Upon completion, the reaction mixture was poured into sol. of NH₄Cl and extracted with Et₂O. Obtained red oil was purified by column chromatography (hexane-ethyl acetate) to give product as a liquid (13.2, yield 74%).

### Synthesis of 2-methyl-1,3-bis(2-(trifluoromethyl)pyridin-4-yl)propane-1,3-dione

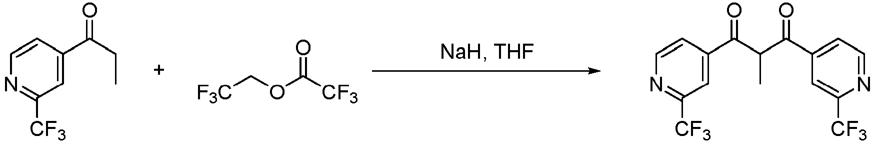

Flask was charged with 1-(2-(trifluoromethyl)pyridin-4-yl)propan-1-one (10.2g, 50 mmol), evacuated and filled with Ar. THF was added, reaction mixture was cooled to 0 °C and NaH (2.4g, 100 mmol) was added. Reaction mixture was stirred for 30 min. and 2,2,2-trifluoroethyl trifluoroacetate (5.9g, 30 mmol) was added dropwise within 20 min and mixture was stirred at 0 °C for 30 min. Upon completion reaction was quenched at 0 °C by diluted HCl and extracted with Et₂O, combined organic layers were washed with water, brine, dried over Na₂SO₄ and solvent was evaporated in vacuo. The residue was purified by column chromatography (Hexane, ethyl acetate). Obtained yellow solid was triturated with 20 mL of Et₂O, filtrated off and washed with cold Et₂O. Colourless product was obtained 4.42 g (47%).

### Synthesis of bis(((Z)-2-methyl-3-oxo-1,3-bis(2-(trifluoromethyl)pyridin-4-yl)prop-1-en-1-yl)oxy)copper (MC-3) / (G4)

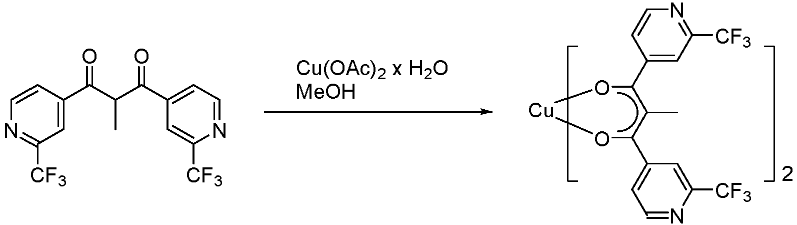

2.50g (6.64mmol) of 2-methyl-1,3-bis(2-(trifluoromethyl)pyridin-4-yl)propane-1,3-dione were dissolved in 25ml methanol and 0.66g (3.32mmol) copper(II) acetate monohydrate and 10ml water were added. The mixture was stirred at room temperature overnight. The precipitate was filtered off, washed with water and dried in high vacuum. The crude product was stirred in 200mL hot ethyl acetate, filtered off and dried in high vacuum to obtain 1.97g (73%) product as a solid.

### Synthesis of bis(((Z)-2-methyl-3-oxo-1,3-bis(2-(trifluoromethyl)pyridin-4-yl)prop-1-en-1-yl)oxy)copper (MC-4) / (G5)

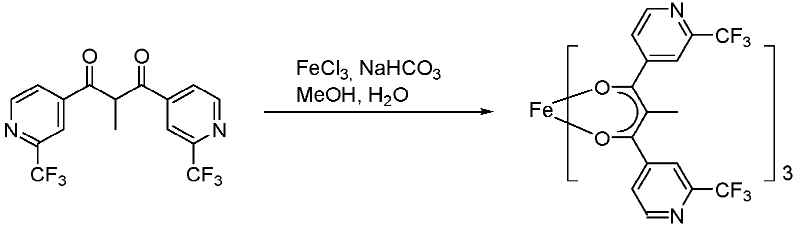

2.98g (7.70mmol) of 2-methyl-1,3-bis(2-(trifluoromethyl)pyridin-4-yl)propane-1,3-dione were dissolved in 60ml methanol and 0.65g (7.70mmol) sodium bicarbonate was added. 0.41g (2.57mmol) iron trichloride were dissolved in 2ml water and added dropwise to the reaction. The mixture was stirred at room temperature overnight. The precipitate was filtered off, washed with water and dried in high vacuum. 0.73g (24%) product were obtained as a solid.

Further compounds according to invention may be prepared by the methods described above or by methods known in the art.

**Table 1: Formulae of comparative compounds CC-1 and CC-2 and compounds of Formula (I) MC-1 to MC-4**

| Name | Formula |
|---|---|
| CC-1 | 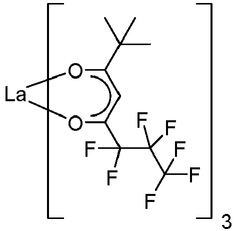 |
| CC-2 | 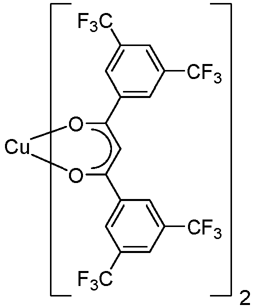 |
| MC-1 | 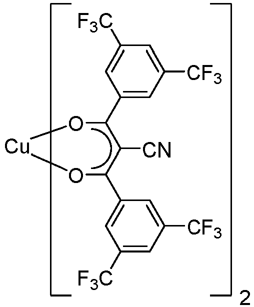 |
| G1 | |
| MC-2 | 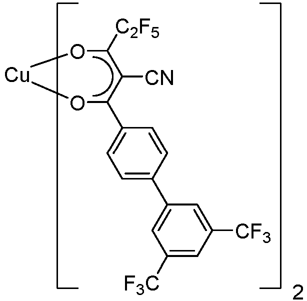 |
| G3 | |
| MC-3 | 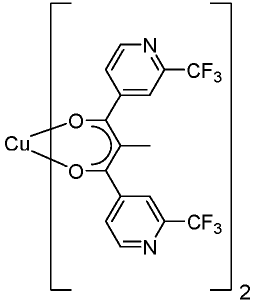 |
| G4 | |
| MC-4 | 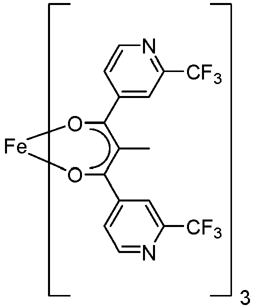 |
| G5 | |

### Compounds of formula (II)

Compounds of formula (II) may be prepared by methods known in the art.

### HOMO and LUMO levels

The HOMO and LUMO levels are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

### General procedure for fabrication of organic electronic devices comprising a hole injection layer comprising a metal complex and a substantially covalent matrix compound

For inventive examples 1-1 to 1-7 and comparative examples 1-1 to 1-4 in Table 2, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen at 75 W for 30 seconds.

Then, the substantially covalent matrix compound and the metal complex were co-deposited in vacuum on the anode layer, to form a hole injection layer (HIL) having a thickness of 10 nm. The composition of the hole injection layer can be seen in Table 2. The formulae of the metal complexes can be seen in Table 1.

Then, the substantially covalent matrix compound was vacuum deposited on the HIL, to form a HTL having a thickness of 123 nm. The substantially covalent matrix compound in the HTL is selected the same as the substantially covalent matrix compound in the HIL. The substantially covalent matrix compound can be seen in Table 2.

Then N-(4-(dibenzo[b,d]furan-4-yl)phenyl)-N-(4-(9-phenyl-9H-fluoren-9-yl)phenyl)-[1,1'-biphenyl]-4-amine (CAS 1824678-59-2) was vacuum deposited on the HTL, to form an electron blocking layer (EBL) having a thickness of 5 nm.

Then 97 vol.-% H09 as EML host and 3 vol.-% BD200 (Sun Fine Chemicals, Korea) as fluorescent blue emitter dopant were deposited on the EBL, to form a blue-emitting first emission layer (EML) with a thickness of 20 nm.

Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.

Then the electron transporting layer having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ.

Then Ag:Mg (90:10 vol.-%) was evaporated at a rate of 0.01 to 1 Å/s at 10⁻⁷ mbar to form a cathode layer with a thickness of 13 nm on the electron transporting layer.

Then, K1 was deposited on the cathode layer to form a capping layer with a thickness of 75 nm.

The OLED stack is protected from ambient conditions by encapsulation of the device with a glass slide. Thereby, a cavity is formed, which includes a getter material for further protection.

### Comparative example 1-5

For comparative example 1-5 in Table 2, a 15Ω /cm² glass substrate with 90 nm ITO (available from Corning Co.) was cut to a size of 50 mm x 50 mm x 0.7 mm, ultrasonically washed with water for 60 minutes and then with isopropanol for 20 minutes. The liquid film was removed in a nitrogen stream, followed by plasma treatment in nitrogen atmosphere at a power of 100 W for 75 seconds to prepare the anode layer.

Then, 90 vol.-% K1 and 10 vol.-% MC-1 were co-deposited in vacuum on the anode layer, to form a hole injection layer (HIL) having a thickness of 10 nm.

Then, K1 was vacuum deposited on the HIL, to form a HTL having a thickness of 123 nm.

Then, the EBL, EML, HBL and ETL are deposited in this order on the HTL, as described for inventive example 1-1.

Then Al was evaporated at a rate of 0.01 to 1 Å/s at 10⁻⁷ mbar to form a cathode layer with a thickness of 100 nm on the electron transporting layer.

The OLED stack is protected from ambient conditions by encapsulation of the device with a glass slide. Thereby, a cavity is formed, which includes a getter material for further protection.

### Comparative example 1-6

For comparative example 1-6 in Table 2, a glass substrate was cut to a size of 50 mm x 50 mm x 0.7 mm, ultrasonically washed with water for 60 minutes and then with isopropanol for 20 minutes. The liquid film was removed in a nitrogen stream, followed by plasma treatment in nitrogen atmosphere at a power of 100 W for 75 seconds, to prepare the substrate.

Then, 100 nm Ag was deposited in vacuum on the substrate to form the anode layer.

Then, 90 vol.-% K1 and 10 vol.-% MC-1 were co-deposited in vacuum on the anode layer, to form a hole injection layer (HIL) having a thickness of 10 nm.

Then, K1 was vacuum deposited on the HIL, to form a HTL having a thickness of 123 nm.

Then, the EBL, EML, HBL and ETL, cathode layer and capping layer are deposited in this order on the HTL, as described for inventive example 1-1.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values. The cd/A efficiency at 10 mA/cm² is determined by interpolating the luminance-voltage and current-voltage characteristics, respectively.

In bottom emission devices, the emission is predominately Lambertian and quantified in percent external quantum efficiency (EQE). The light is emitted through the anode layer. To determine the efficiency EQE in % the light output of the device is measured using a calibrated photodiode at 10 mA/cm2.

In top emission devices, the emission is forward directed through the cathode layer, non-Lambertian and also highly dependent on the mirco-cavity. Therefore, the efficiency EQE will be higher compared to bottom emission devices. To determine the efficiency EQE in % the light output of the device is measured using a calibrated photodiode at 10 mA/cm².

Lifetime LT of the device is measured at ambient conditions (20°C) and 30 mA/cm², using a Keithley 2400 sourcemeter, and recorded in hours.

The brightness of the device is measured using a calibrated photo diode. The lifetime LT is defined as the time till the brightness of the device is reduced to 97 % of its initial value.

To determine the voltage stability over time U(100h)-(1h), a current density of at 30 mA/cm² was applied to the device. The operating voltage was measured after 1 hour and after 100 hours, followed by calculation of the voltage stability for the time period of 1 hour to 100 hours.

### Technical Effect of the invention

In Table 2 are shown data for top emission organic electronic devices fabricated by codeposition from vacuum of metal complex and substantially covalent matrix compound.

In comparative examples 1-1 to 1-4, two metal complexes known in the art are tested at two different doping concentrations.

As can be seen in Table 2, in comparative examples 1-1 to 1-4 the operating voltage is between 3.67 and 3.78 V, the external quantum efficiency EQE is between 12.9 and 13.91 % and the voltage stability over time is between 0.85 and 1.28 V.

In comparative example 1-5, the anode layer consists of ITO. As can be seen in Table 2, the operating voltage is increased compared to comparative examples 1-1 to 1-4 and the efficiency is reduced. The operating voltage stability over time is reduced compared to comparative examples 1-1 to 1-4.

In comparative example 1-6, the anode layer consists of Ag. As can be seen in Table 2, the operating voltage is substantially increased compared to comparative examples 1-1 to 1-4 and the efficiency is substantially reduced. The operating voltage stability over time is substantially reduced compared to comparative examples 1-1 to 1-4.

In inventive example 1-1, the semiconductor layer comprises metal complex of formula (I) MC-1. MC-1 comprises a group R² selected from CN. As can be seen in Table 2, the EQE is improved to 14.32 % and operating voltage stability over time is improved to 0.46 V compared to comparative example 1-4. The performance in inventive example 1-1 is substantially improved compared to comparative examples 1-5 and 1-6, which do not comprise an anode layer according to invention.

In inventive examples 1-2, the semiconductor layer comprises 15 vol.-% MC-1. As can be seen in Table 2, EQE and operating voltage stability over time remain improved over comparative examples 1-1 to 1-4.

In inventive examples 1-3 to 1-7, the semiconductor layer comprises metal complex of formula (1) at a range of doping concentrations and substantially covalent matrix compounds with a range of HOMO levels. As can be seen in Table 2, EQE and operating voltage stability over time are improved over comparative examples 1-1 to 1-4.

A high efficiency and/or improved operating voltage stability over time are important for the performance and long-term stability of organic electronic devices.

**Table 2: Organic electronic devices comprising a hole injection layer comprising a metal complex and a matrix compound**

| | Anode | Metal complex | Percentage metal complex in semiconduct or layer [vol.-%] | Matrix compound | HOMO level of matrix compound [eV] | Percentage matrix compound in semiconductor layer [vol.-%] | U at 10 mA/cm² [V] | Cd/A efficiency at 10 mA/cm² [cd/A] | EQE at 10 mA/cm² [%] | U(100 h)-U(1 h) at 30mA/cm² [V] |
|---|---|---|---|---|---|---|---|---|---|---|
| Comparative example 1-1 | ITO/Ag/ITO | CC-1 | 5 | K1 | -4.68 | 95 | 3.67 | 6.38 | 12.99 | 0.85 |
| Comparative example 1-2 | ITO/Ag/ITO | CC-2 | 6 | K1 | -4.68 | 94 | 3.8 | 7.0 | 13.91 | 1.24 |
| Comparative example 1-3 | ITO/Ag/ITO | CC-1 | 9 | K1 | -4.68 | 91 | 3.65 | 6.24 | 12.90 | 0.89 |
| Comparative example 1-4 | ITO/Ag/ITO | CC-2 | 10 | K1 | -4.68 | 90 | 3.78 | 6.92 | 13.81 | 1.28 |
| Comparative example 1-5 | ITO | MC-1 | 10 | K1 | -4.68 | 90 | 4.06 | 5.21 | 10.38 | 1.98 |
| Comparative example 1-6 | Ag | MC-1 | 10 | K1 | -4.68 | 90 | > 10 | <3 | <6 | >2 |
| Inventive example 1-1 | ITO/Ag/ITO | MC-1 | 10 | K1 | -4.68 | 90 | 3.75 | 6.73 | 14.32 | 0.46 |
| Inventive example 1-2 | ITO/Ag/ITO | MC-1 | 15 | K1 | -4.68 | 85 | 3.73 | 6.70 | 14.36 | 0.47 |
| Inventive example 1-3 | ITO/Ag/ITO | MC-1 | 18 | K16 | -4.73 | 82 | 3.81 | 7.34 | 15.42 | 0.07 |
| Inventive example 1-4 | ITO/Ag/ITO | MC-1 | 22 | K16 | -4.73 | 78 | 3.8 | 7.31 | 15.44 | 0.06 |
| Inventive example 1-5 | ITO/Ag/ITO | MC-1 | 15 | K2 | -4.85 | 85 | 3.75 | 7.25 | 14.73 | 0.06 |
| Inventive example 1-6 | ITO/Ag/ITO | MC-1 | 21 | K2 | -4.85 | 79 | 3.74 | 7.23 | 14.72 | 0.03 |
| Inventive example 1-7 | ITO/Ag/ITO | MC-1 | 25 | K2 | -4.85 | 75 | 3.73 | 7.21 | 14.71 | 0.02 |

The particular combinations of elements and features in the above detailed embodiments are exemplary only. As those skilled in the art will recognize, variations, modifications, and other implementations of what is described herein can occur to those of ordinary skill in the art without departing from the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims. Furthermore, reference signs used in the description and claims do not limit the scope of the invention as claimed.

## Claims

1. An organic electronic device (100) comprising a substrate (110), an anode layer (120), a cathode layer (190), at least one first emission layer(150), and a hole injection layer (130), wherein the hole injection layer (130) comprises a metal complex, wherein the metal complex has the formula (I): 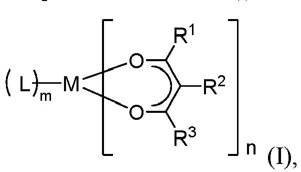 wherein
M is a metal;
L is a charge-neutral ligand, which coordinates to the metal M;
n is an integer selected from 1 to 4, which corresponds to the oxidation number of M;
m is an integer selected from 0 to 2;
R¹ and R³ are independently selected from H, D, substituted or unsubstituted C₁ to C₁₂ alkyl, substituted or unsubstituted C₁ to C₁₂ alkoxy, substituted or unsubstituted C₆ to C₂₄ aryl, and substituted or unsubstituted C₂ to C₂₄ heteroaryl group, wherein
at least one substituent is selected from halogen, F, Cl, CN, substituted or unsubstituted C₁ to C₁₂ alkyl, partially or fully fluorinated C₁ to C₁₂ alkyl, substituted or unsubstituted C₁ to C₁₂ alkoxy, partially or fully fluorinated C₁ to C₁₂ alkoxy, substituted or unsubstituted C₆ to C₁₈ aryl, and substituted or unsubstituted C₂ to C₁₈ heteroaryl, wherein
the substituents of the substituted or unsubstituted C₁ to C₁₂ alkyl, substituted or unsubstituted C₁ to C₁₂ alkoxy, substituted or unsubstituted C₆ to C₁₈ aryl, and substituted or unsubstituted C₂ to C₁₈ heteroaryl are selected from halogen, F, Cl, CN, C₁ to C₆ alkyl, CF₃, OCH₃, OCF₃;
R² is selected from CN, C₁ to C₄ alkyl, partially or perfluorinated C₁ to C₄ alkyl, or F;
- the anode layer (120) comprises a first anode sub-layer (121) and a second anode sub-layer (122),
wherein
- the first anode sub-layer (121) comprises a first metal having a work function in the range of ≥ 4 and ≤ 6 eV,
- the second anode sub-layer (122) comprises a transparent conductive oxide;
- the hole injection layer (130) is arranged between the first emission layer(150) and the anode layer (120),
- the first anode sub-layer (121) is arranged closer to the substrate (110), and
- the second anode sub-layer (122) is arranged closer to the hole injection layer (130);
wherein the compounds A1 to A18 are excluded from Formula (I):

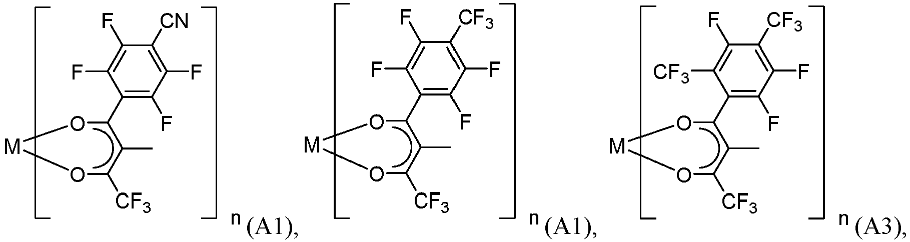

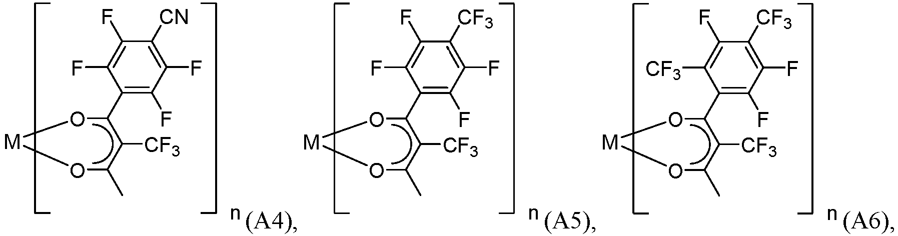

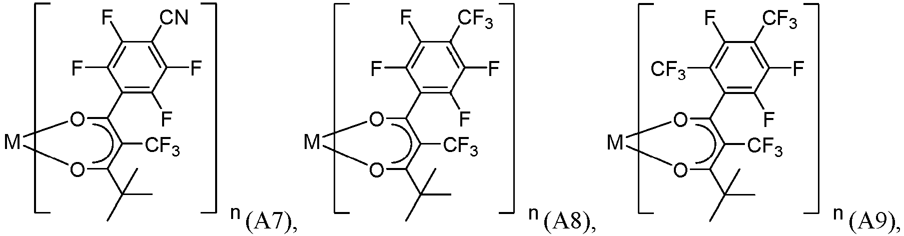

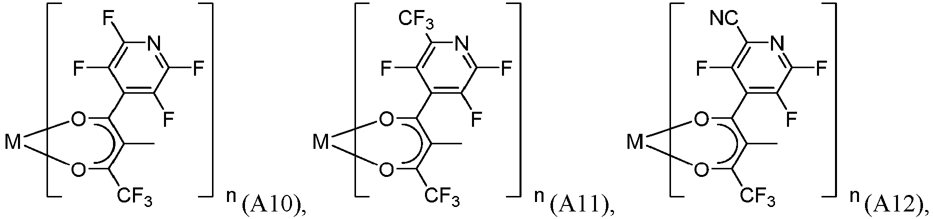

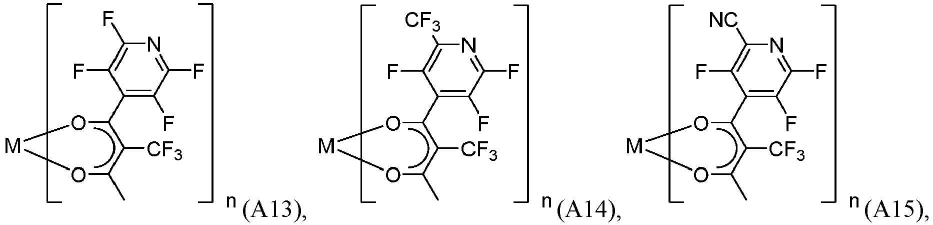

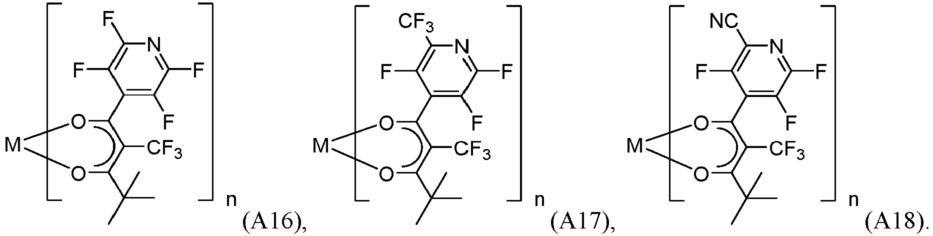

2. The organic electronic device (100) according to claim 1, wherein R² is selected from CN, CH₃, CF₃, C₂F₅, C₃F₇ or F, more preferred CN, CH₃, CF₃, C₂F₅, C₃F₇.

3. The organic electronic device (100) according to claim 1 or 2, wherein at least one R¹ and/or R³ is selected from a substituted C₆ to C₂₄ aryl or substituted C₂ to C₂₄ heteroaryl group, wherein at least one substituent or at least two substituents of the substituted C₆ to C₂₄ aryl or substituted C₂ to C₂₄ heteroaryl group is selected from CN or partially or fully fluorinated C₁ to C₁₂ alkyl, preferably partially or fully fluorinated C₁ to C₄ alkyl, and more preferred selected from CN CF₃, C₂F₅ or C₃F₇.

4. The organic electronic device (100) according to any of claims 1 to 3, wherein at least one R¹ or R³, or R¹ and R³ are selected from a substituted C₂ to C₂₄ heteroaryl group, wherein
- the substituted heteroaryl group comprises at least one six-membered ring; and/or
- the substituted heteroaryl group comprises at least 1 to 6 N atoms, preferably 1 to 3 N atoms, and more preferred 1 N atom; and/or
- the heteroaryl group of the substituted heteroaryl group is a six-membered ring, comprising 1, 2 or 3 hetero atoms, wherein preferably the hetero atom is N.

5. The organic electronic device (100) according to any of claims 1 to 4, wherein at least one substituted or unsubstituted C₆ to C₂₄ aryl group and/or substituted or unsubstituted C₂ to C₂₄ heteroaryl group of R¹ and/or R³ is selected from the following Formulas D1 to D71: 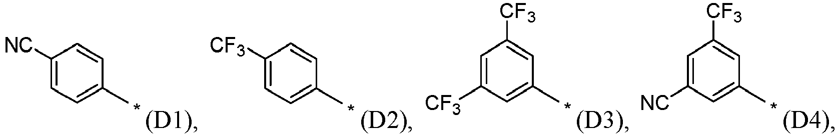 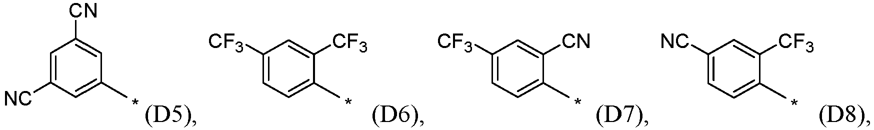 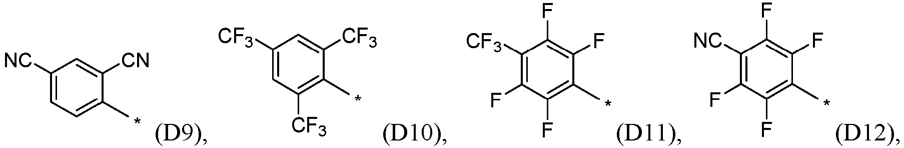 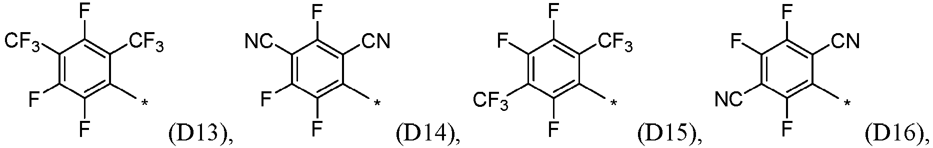 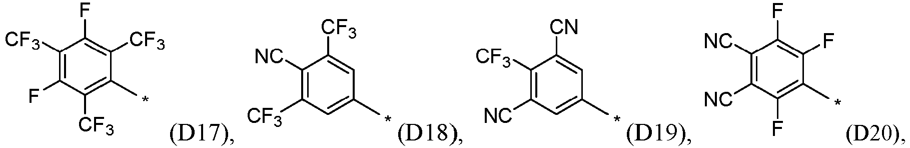 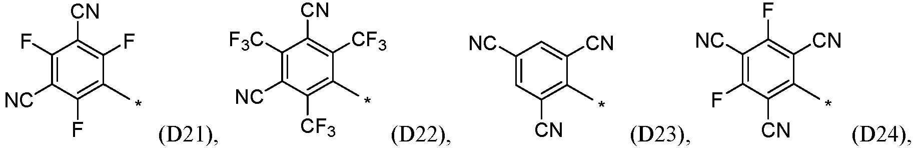 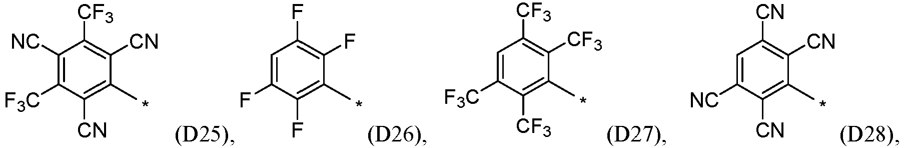 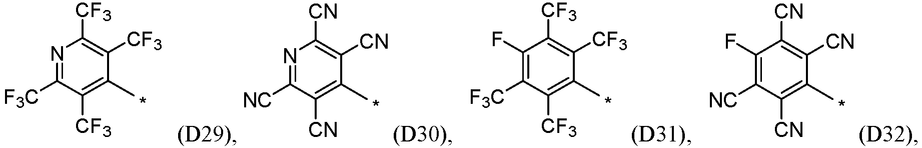 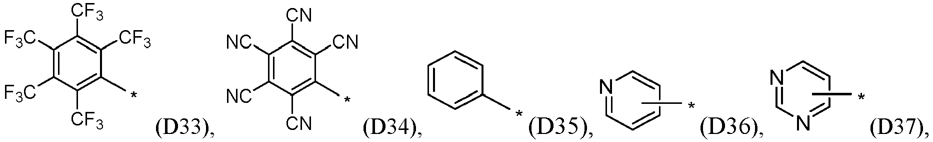 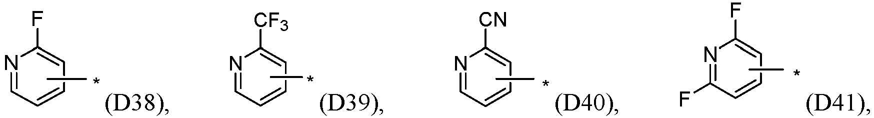 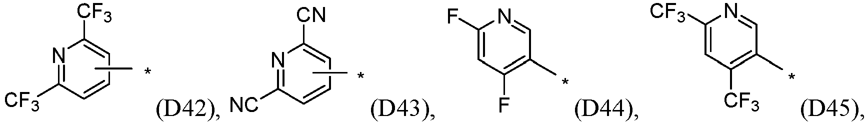 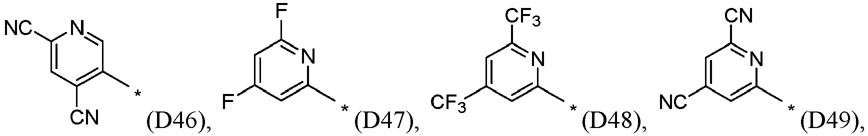 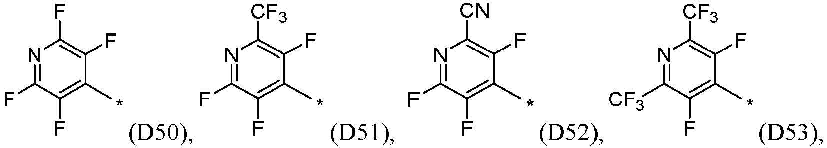 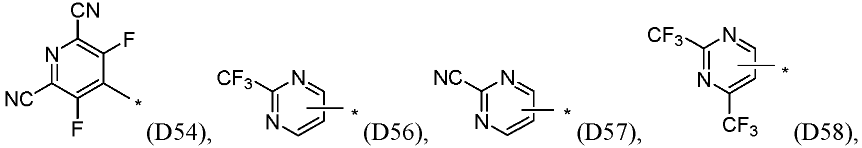 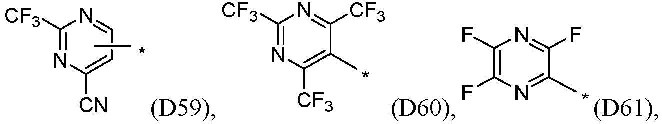 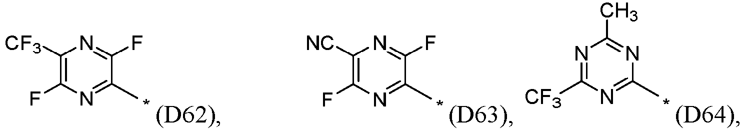 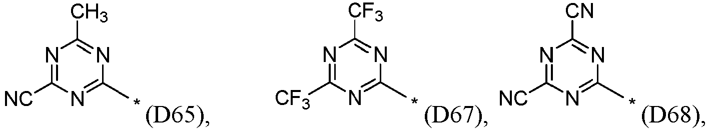 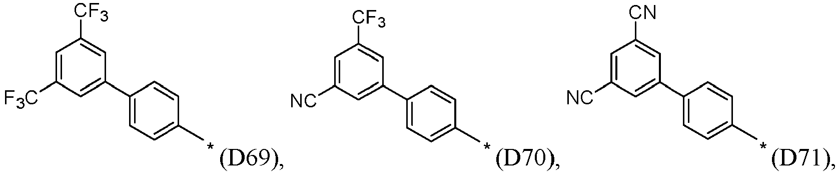 wherein the "*" denotes the binding position.

6. The organic electronic device (100) according to any of claims 1 to 5, wherein the metal complex is represented by Formula I and is selected from the following Formulas E1 to E20: 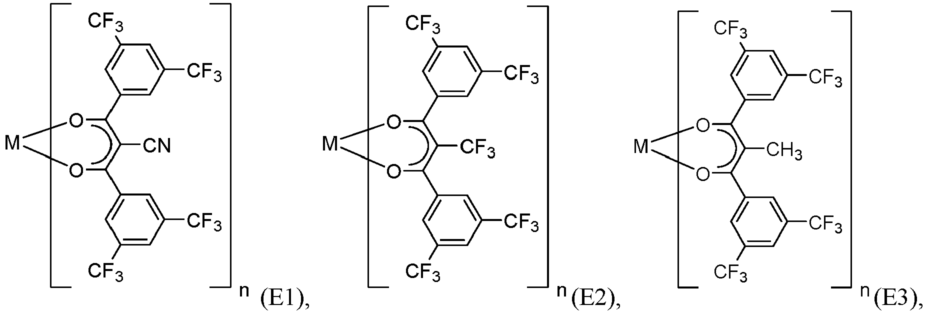 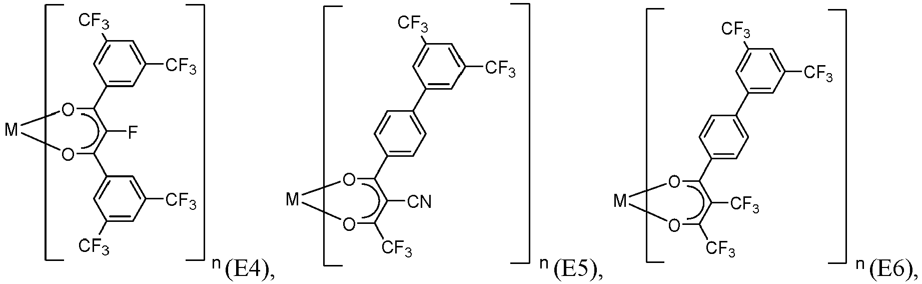 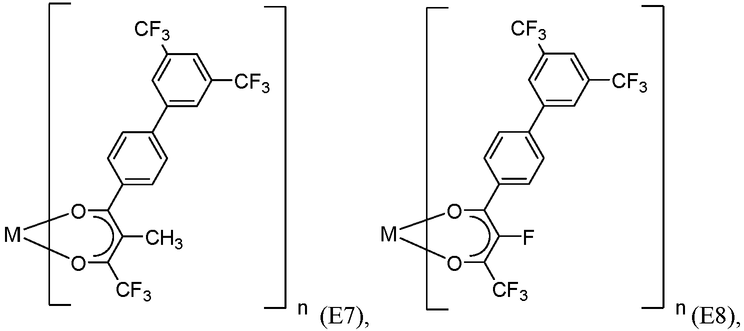 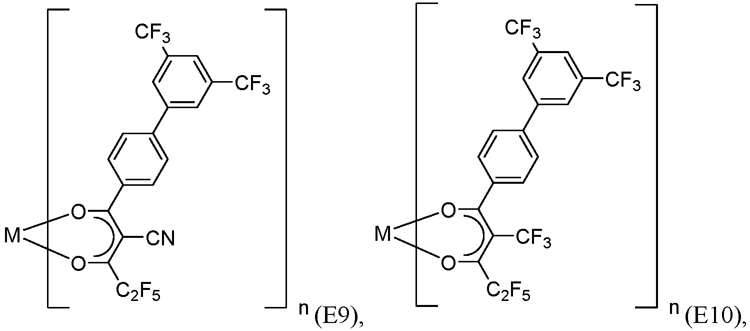 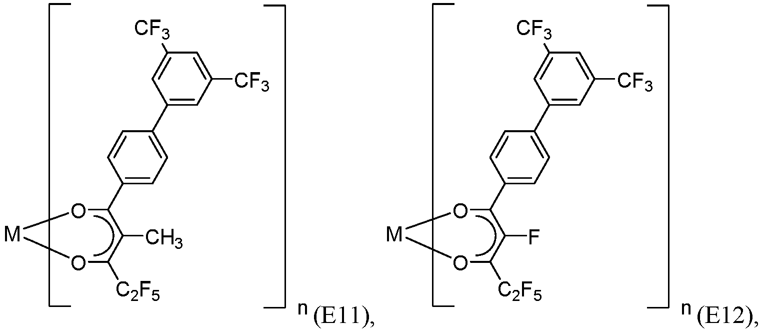 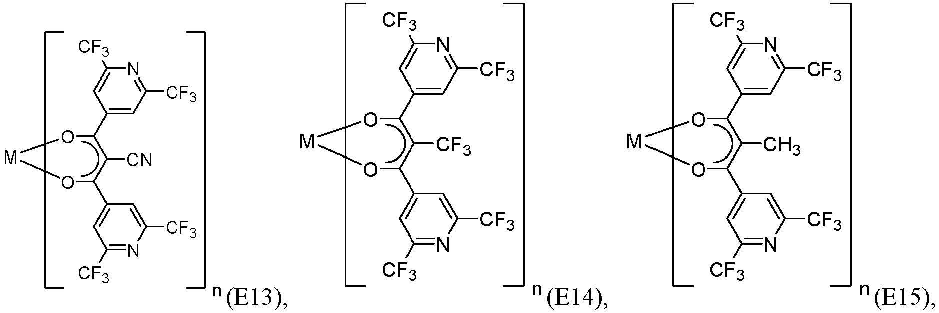 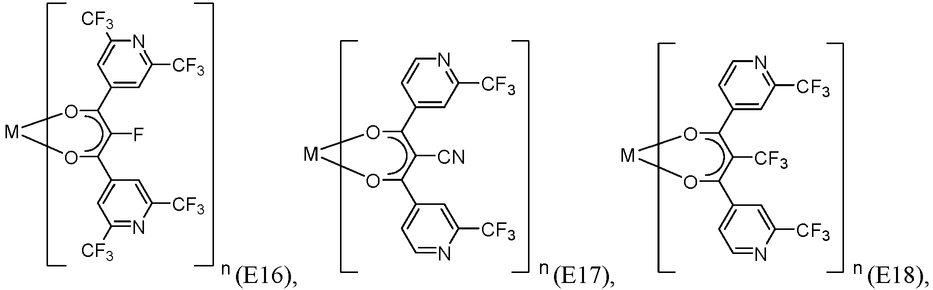 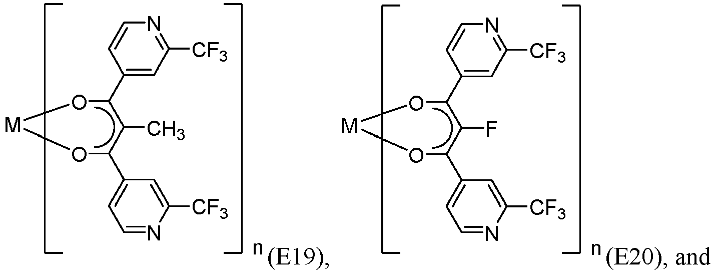 more preferred wherein M is Cu(II) or Fe(III).

7. The organic electronic device (100) according to any of claims 1 to 6, wherein the metal complex is represented by Formula I and is selected from the following Formulas G1 to G7:

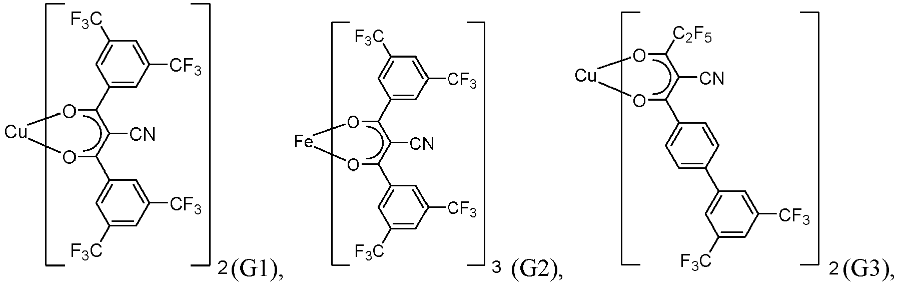

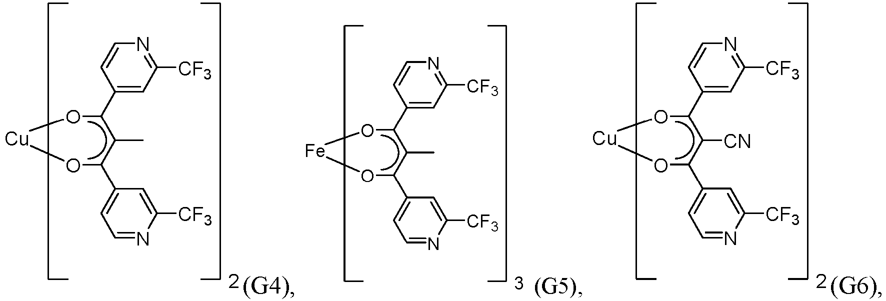

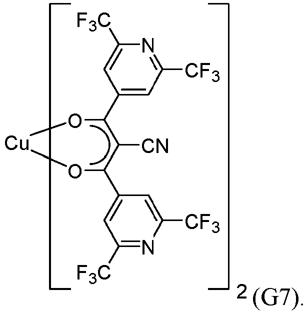

8. The organic electronic device (100) according to any of claims 1 to 6, wherein the metal M is selected from alkali, alkaline earth, transition, rare earth metal or group III to V metal, preferably the metal M is selected from transition or group III to V metal; preferably the metal M is selected from Li(I), Na(I), K(I), Rb(I), Cs(I), Cu(II), Zn(II), Pd(II), Al(III), Sc(III), Mn(III), In(III), Y(III), Eu(III), Fe(III), Zr(IV), Hf(IV) or Ce(IV), more preferred M is Cu(II) or Fe(III), and further more preferred M is Cu(II).

9. The organic electronic device (100) according to any of claims 1 to 5 and 8, wherein L is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile or C₂ to C₄₀ aryl nitrile, or a compound according to Formula (II); 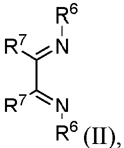 wherein
R⁶ and R⁷ are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

10. The organic electronic device (100) according to any of claims 1 to 9, wherein n is an integer selected from 1, 2 and 3, preferably 2, which corresponds to the oxidation number of M.

11. The organic electronic device (100) according to any of claims 1 to 5 and 8 to 10, wherein m is an integer selected from 0 or 1, preferably 0.

12. The organic electronic device (100) according to any of preceding claims 1 to 11, wherein the organic electronic device (100) further comprises a hole transport layer (140), wherein the hole transport layer (140) is arranged between the hole injection layer (130) and the at least one emission layer (150).

13. The organic electronic device (100) according to claim 12, wherein the hole transport layer (140) comprises a covalent matrix compound, preferably a substantially covalent matrix compound, wherein the covalent matrix compound, preferably the substantially covalent matrix compound, in the hole injection layer (130) and hole transport layer (140) are selected the same.

14. The organic electronic device (100) according to any of the preceding claims 1 to 13, wherein the organic electronic device (100) is a light emitting device or a display device.

## Patentansprüche

1. Organische elektronische Vorrichtung (100), die ein Substrat (110), eine Anodenschicht (120), eine Kathodenschicht (190), mindestens eine erste Emissionsschicht (150) und eine Lochinjektionsschicht (130) umfasst, wobei die Lochinjektionsschicht (130) einen Metallkomplex umfasst, wobei der Metallkomplex die Formel (I) aufweist: 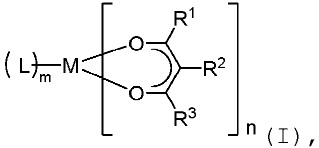 wobei
M ein Metall ist;
L ein ladungsneutraler Ligand ist, der an das Metall M koordiniert;
n eine ganze Zahl ausgewählt aus 1 bis 4 ist, die der Oxidationszahl von M entspricht;
m eine ganze Zahl ausgewählt aus 0 bis 2 ist;
R¹ und R³ unabhängig ausgewählt sind aus H, D, substituiertem oder unsubstituiertem C₁- bis C₁₂-Alkyl , substituiertem oder unsubstituiertem C₁- bis C₁₂-Alkoxy, substituiertem oder unsubstituiertem C₆- bis C₂₄-Aryl und substituierter oder unsubstituierter C₂- bis C₂₄-Heteroarylgruppe, wobei
wenigstens ein Substituent ausgewählt ist aus Halogen, F, Cl, CN, substituiertem oder unsubstituiertem C₁- bis C₁₂-Alkyl, teilweise oder vollständig fluoriertem C₁- bis C₁₂-Alkyl, substituiertem oder unsubstituiertem C₁- bis C₁₂-Alkoxy, teilweise oder vollständig fluoriertem C₁- bis C₁₂-Alkoxy, substituiertem oder unsubstituiertem C₆- bis C₁₈-Aryl und substituiertem oder unsubstituiertem C₂- bis C₁₈-Heteroaryl, wobei
die Substituenten des substituierten oder unsubstituierten C₁- bis C₁₂-Alkyls, substituierten oder unsubstituierten C₁- bis C₁₂-Alkoxys, substituierten oder unsubstituierten C₆- bis C₁₈-Aryls und substituierten oder unsubstituierten C₂- bis C₁₈-Heteroaryls ausgewählt sind aus Halogen, F, Cl, CN, C₁- bis C₆-Alkyl, CF₃, OCH₃, OCF₃; R² ausgewählt ist aus CN, C₁- bis C₄-Alkyl, teilweise oder perfluoriertem C₁- bis C₄-Alkyl oder F;
- die Anodenschicht (120) eine erste Anodenunterschicht (121) und eine zweite Anodenunterschicht (122) umfasst,
wobei
- die erste Anodenunterschicht (121) ein erstes Metall mit einer Arbeitsfunktion im Bereich von ≥ 4 und ≤ 6 eV umfasst,
- die zweite Anodenunterschicht (122) ein transparentes leitfähiges Oxid umfasst;
- die Lochinjektionsschicht (130) zwischen der ersten Emissionsschicht (150) und der Anodenschicht (120) angeordnet ist,
- die erste Anodenunterschicht (121) näher an dem Substrat (110) angeordnet ist, und
- die zweite Anodenunterschicht (122) näher an der Lochinjektionsschicht (130) angeordnet ist;
wobei die Verbindungen A1 bis A18 von Formel (I) ausgeschlossen sind:

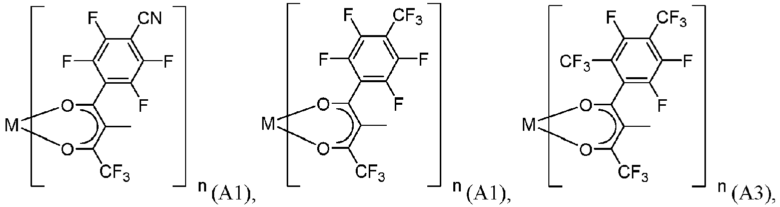

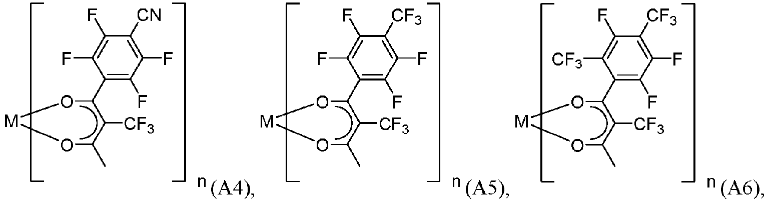

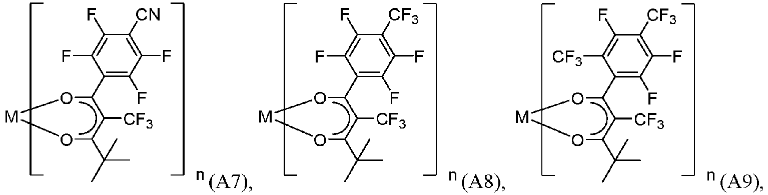

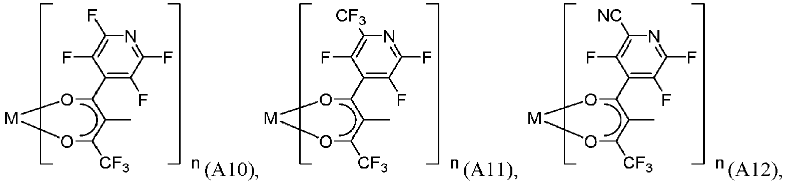

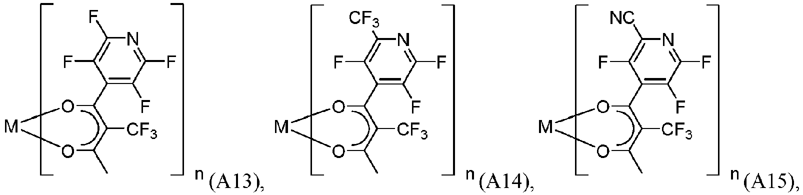

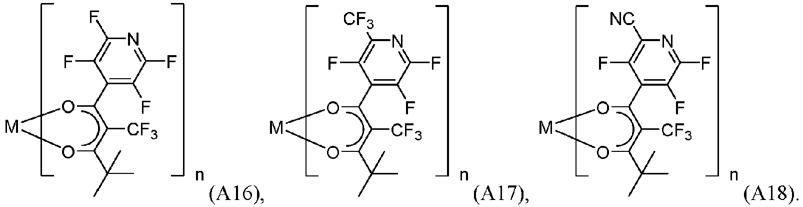

2. Organische elektronische Vorrichtung (100) nach Anspruch 1, wobei R² ausgewählt ist aus CN, CH₃, CF₃, C₂F₅, C₃F₇ oder F, bevorzugter CN, CH₃, CF₃, C₂F₅, C₃F₇.

3. Organische elektronische Vorrichtung (100) nach Anspruch 1 oder 2, wobei mindestens ein R¹ und/oder R³ ausgewählt ist aus einer substituierten C₆- bis C₂₄-Aryl- oder substituierten C₂- bis C₂₄-Heteroarylgruppe, wobei mindestens ein Substituent oder mindestens zwei Substituenten der substituierten C₆- bis C₂₄-Aryl- oder substituierten C₂- bis C₂₄-Heteroarylgruppe ausgewählt ist/sind aus CN oder teilweise oder vollständig fluoriertem C₁- bis C₁₂-Alkyl, vorzugsweise teilweise oder vollständig fluoriertem C₁- bis C₄-Alkyl, und bevorzugter ausgewählt ist/sind aus CN CF₃, C₂F₅ oder C₃F₇.

4. Organische elektronische Vorrichtung (100) nach einem der Ansprüche 1 bis 3, wobei mindestens ein R¹ oder R³ oder R¹ und R³ aus einer substituierten C₂-C₂₄-Heteroarylgruppe ausgewählt sind, wobei
- die substituierte Heteroarylgruppe mindestens einen sechsgliedrigen Ring umfasst; und/oder
- die substituierte Heteroarylgruppe mindestens 1 bis 6 N-Atome, vorzugsweise 1 bis 3 N-Atome und besonders bevorzugt 1 N-Atom umfasst; und/oder
- die Heteroarylgruppe der substituierten Heteroarylgruppe ein sechsgliedriger Ring ist, der 1, 2 oder 3 Heteroatome umfasst, wobei das Heteroatom vorzugsweise N ist

5. Organische elektronische Vorrichtung (100) nach einem der Ansprüche 1 bis 4, wobei mindestens eine substituierte oder unsubstituierte C₆- bis C₂₄-Arylgruppe und/oder substituierte oder unsubstituierte C₂- bis C₂₄-Heteroarylgruppe von R¹ und/oder R³ aus den folgenden Formeln D1 bis D71 ausgewählt ist: 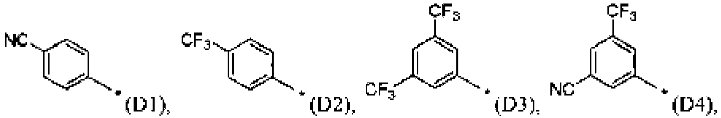 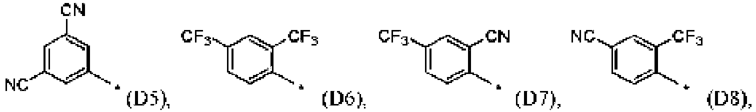 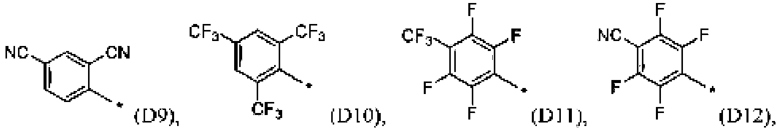 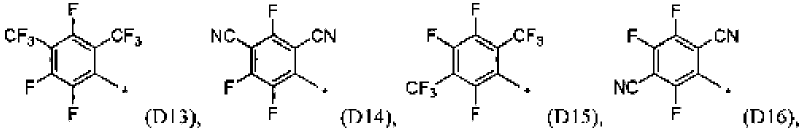 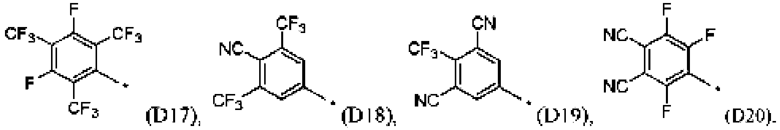 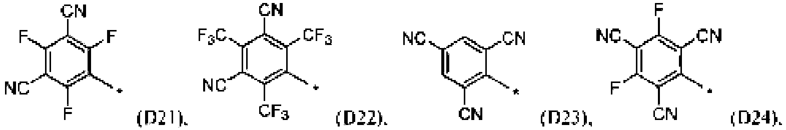 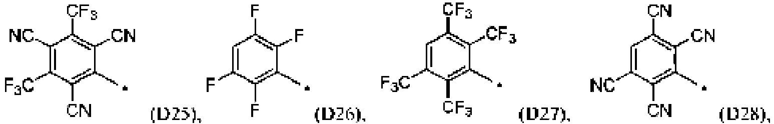 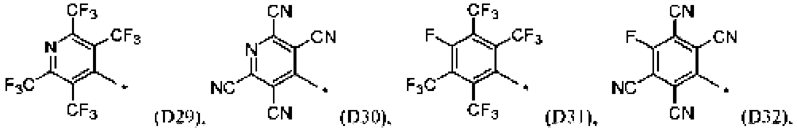 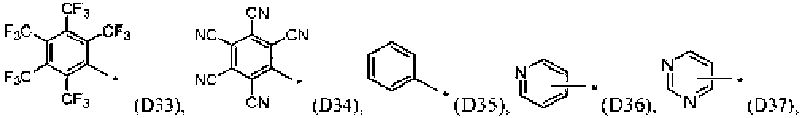 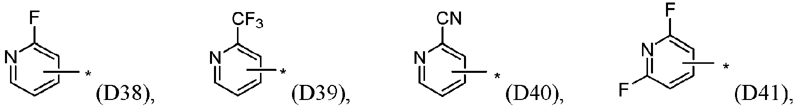 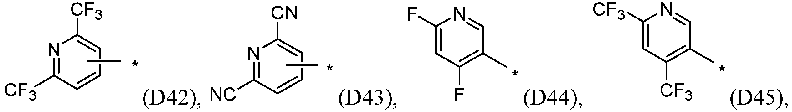 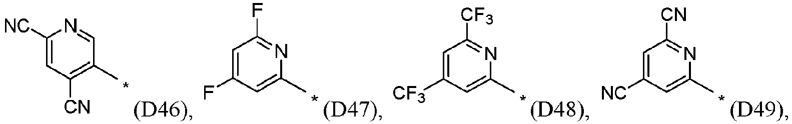 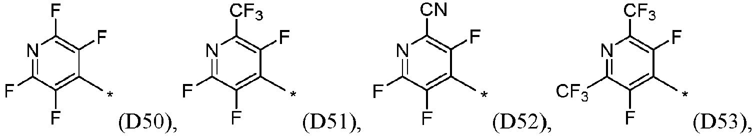 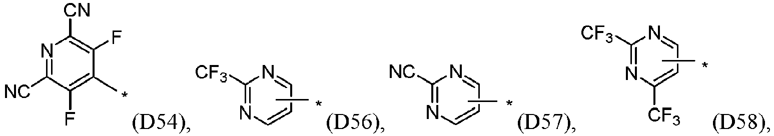 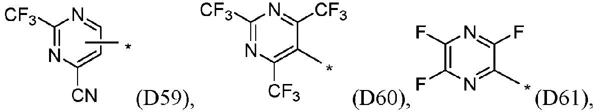 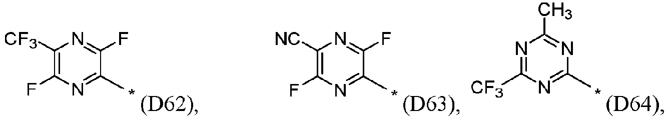 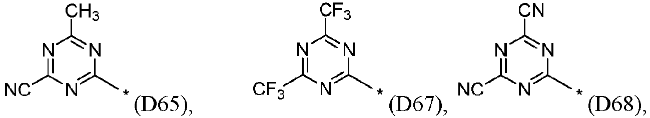 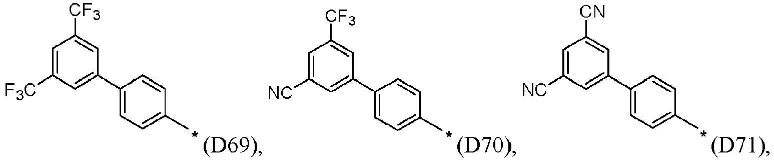 wobei das "*" die Bindungsposition bezeichnet.

6. Organische elektronische Vorrichtung (100) nach einem der Ansprüche 1 bis 5, wobei der Metallkomplex durch Formel I repräsentiert wird und aus den folgenden Formeln E1 bis E20 ausgewählt ist: 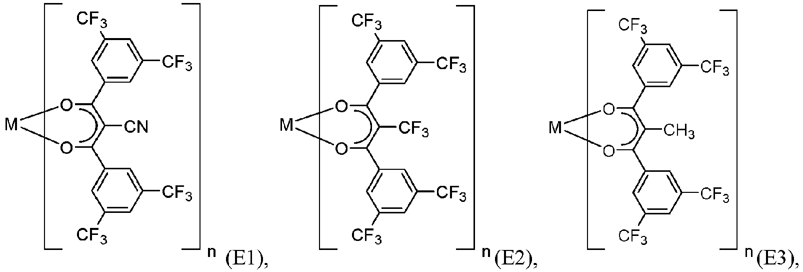 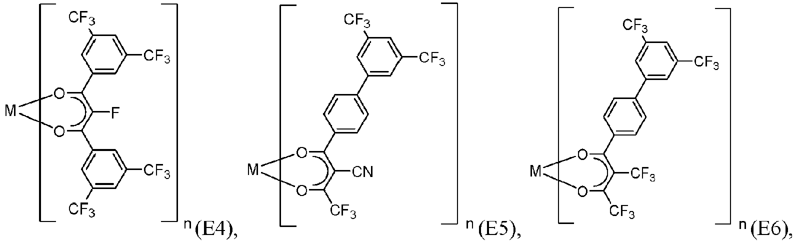 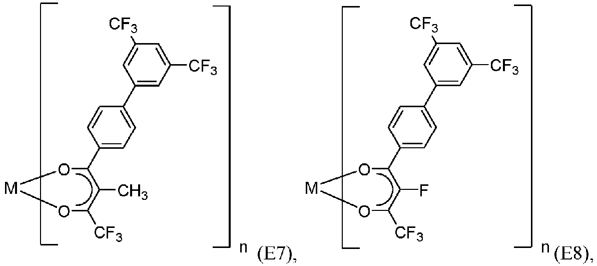 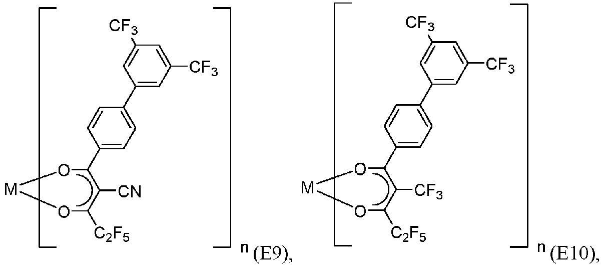 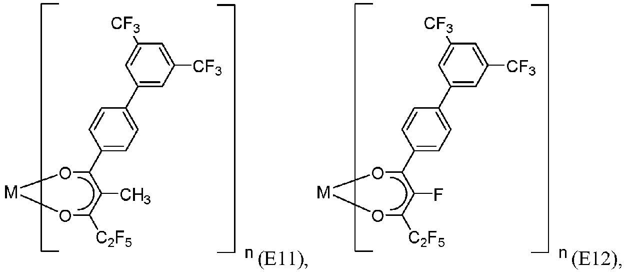 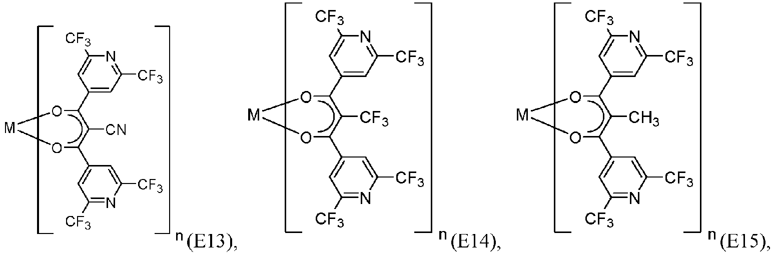 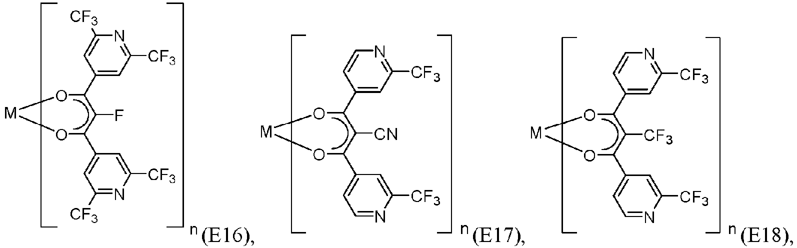 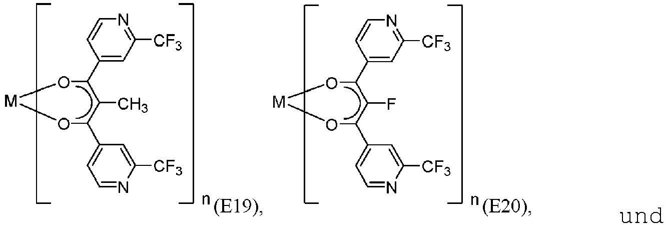 weiter bevorzugt, wobei M Cu(II) oder Fe(III) ist.

7. Organische elektronische Vorrichtung (100) nach einem der Ansprüche 1 bis 6, wobei der Metallkomplex durch Formel I wiedergegeben wird und aus den folgenden Formeln G1 bis G7 ausgewählt ist:

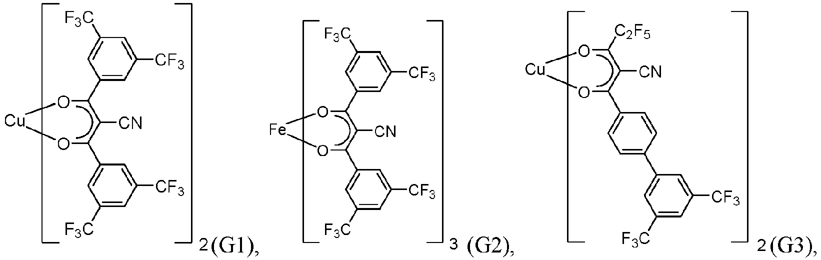

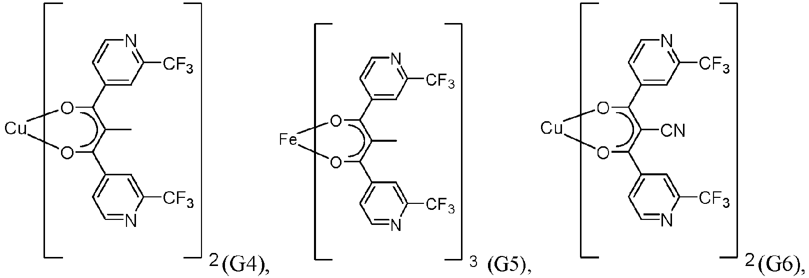

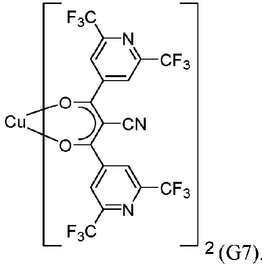

8. Organische elektronische Vorrichtung (100) nach einem der Ansprüche 1 bis 6, wobei das Metall M ausgewählt ist aus Alkali-, Erdalkali-, Übergangs-, Seltenerdmetall oder einem Metall der Gruppe III bis V, vorzugsweise ist das Metall M ausgewählt aus einem Übergangs- oder einem Metall der Gruppe III bis V; vorzugsweise ist das Metall M ausgewählt aus Li(I), Na(I), K(I), Rb(I), Cs(I), Cu(II), Zn(II), Pd(II), Al(III), Sc(III), Mn(III), In(III), Y(III), Eu(III), Fe(III), Zr(IV), Hf(IV) oder Ce(IV), wobei M bevorzugt Cu(II) oder Fe(III) ist, und noch bevorzugter M Cu(II) ist.

9. Organische elektronische Vorrichtung (100) nach einem der Ansprüche 1 bis 5 und 8, wobei L aus der Gruppe ausgewählt ist, die H₂O, C₂- bis C₄₀-Mono- oder Multidentatether und C₂- bis C₄₀-Thioether, C₂- bis C₄₀-Amine, C₂- bis C₄₀-Phosphin, C₂- bis C₂₀-Alkylnitril oder C₂- bis C₄₀-Arylnitril oder eine Verbindung gemäß Formel (II) umfasst; 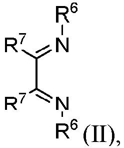 wobei
R⁶ und R⁷ unabhängig voneinander ausgewählt sind aus C₁-bis C₂₀-Alkyl, C₁- bis C₂₀-Heteroalkyl, C₆- bis C₂₀-Aryl, Heteroaryl mit 5 bis 20 ringbildenden Atomen, halogeniertem oder perhalogeniertem C₁- bis C₂₀-Alkyl, halogeniertem oder perhalogeniertem C₁- bis C₂₀-Heteroalkyl, halogeniertem oder perhalogeniertem C₆- bis C₂₀-Aryl, halogeniertes oder perhalogeniertes Heteroaryl mit 5 bis 20 ringbildenden Atomen, oder mindestens ein R⁶ und R⁷ sind verbrückt und bilden einen 5- bis 20-gliedrigen Ring, oder die beiden R⁶ und/oder die beiden R⁷ sind verbrückt und bilden einen 5- bis 40-gliedrigen Ring oder bilden einen 5- bis 40-gliedrigen Ring, der ein unsubstituiertes oder C₁- bis C₁₂-substituiertes Phenanthrolin enthält.

10. Organische elektronische Vorrichtung (100) nach einem der Ansprüche 1 bis 9, wobei n eine ganze Zahl, ausgewählt aus 1, 2 und 3, vorzugsweise 2, ist, die der Oxidationszahl von M entspricht.

11. Organische elektronische Vorrichtung (100) nach einem der Ansprüche 1 bis 5 und 8 bis 10, wobei m eine ganze Zahl ist, die aus 0 oder 1, vorzugsweise 0, ausgewählt ist.

12. Organische elektronische Vorrichtung (100) nach einem der vorhergehenden Ansprüche 1 bis 11, wobei die organische elektronische Vorrichtung (100) ferner eine Lochtransportschicht (140) umfasst, wobei die Lochtransportschicht (140) zwischen der Lochinjektionsschicht (130) und der mindestens einen Emissionsschicht (150) angeordnet ist.

13. Organische elektronische Vorrichtung (100) nach Anspruch 12, wobei die Lochtransportschicht (140) eine kovalente Matrixverbindung, vorzugsweise eine im Wesentlichen kovalente Matrixverbindung, umfasst, wobei die kovalente Matrixverbindung, vorzugsweise die im Wesentlichen kovalente Matrixverbindung, in der Lochinjektionsschicht (130) und der Lochtransportschicht (140) gleich ausgewählt sind.

14. Organische elektronische Vorrichtung (100) nach einem der vorhergehenden Ansprüche 1 bis 13, wobei die organische elektronische Vorrichtung (100) eine Lichtemissionsvorrichtung oder eine Anzeigevorrichtung ist.

## Revendications

1. Dispositif électronique organique (100) comprenant un substrat (110), une couche d'anode (120), une couche de cathode (190), au moins une première couche d'émission (150), et une couche d'injection de trous (130), dans lequel la couche d'injection de trous (130) comprend un complexe métallique, le complexe métallique répondant à la formule (I) : 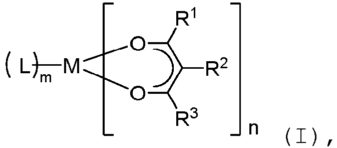 dans laquelle
M est un métal ;
L est un ligand de charge neutre, qui est coordonné au métal M ;
n est un entier choisi de 1 à 4, qui correspond à l'indice d'oxydation de M ;
m est un entier choisi de 0 à 2 ;
R¹ et R³ sont indépendamment choisis parmi H, D, un alkyle en C₁ à C₁₂ substitué ou non substitué, un alcoxy en C₁ à C₁₂ substitué ou non substitué, un aryle en C₆ à C₂₄ substitué ou non substitué, et un hétéroaryle en C₂ à C₂₄ substitué ou non substitué,
au moins un substituant étant choisi parmi un halogène, F, Cl, CN, un alkyle en C₁ à C₁₂ substitué ou non substitué, un alkyle en C₁ à C₁₂ partiellement ou entièrement fluoré, un alcoxy en C₁ à C₁₂ substitué ou non substitué, un alcoxy en C₁ à C₁₂ partiellement ou entièrement fluoré, un aryle en C₆ à C₁₈ substitué ou non substitué, et un hétéroaryle en C₂ à C₁₈ substitué ou non substitué,
les substituants de l'alkyle en C₁ à C₁₂ substitué ou non substitué, de l'alcoxy en C₁ à C₁₂ substitué ou non substitué, de l'aryle en C₆ à C₁₈ substitué ou non substitué et de l'hétéroaryle en C₂ à C₁₈ substitué ou non substitué étant choisis parmi un halogène, F, Cl, CN, un alkyle en C₁ à C₆, CF₃, OCH₃ et OCF₃ ;
R² étant choisi parmi CN, un alkyle en C₁ à C₄, un alkyle en C₁ à C₄ partiellement fluoré ou perfluoré, ou F ;
- la couche d'anode (120) comprenant une première sous-couche d'anode (121) et une seconde sous-couche (122) d'anode,
dans lequel
- la première sous-couche d'anode (121) comprend un premier métal ayant un travail de sortie dans la plage de ≥ 4 à ≤ 6 eV, et
- la seconde sous-couche d'anode (122) comprend un oxyde conducteur transparent ;
- la couche d'injection de trous (130) est agencée entre la première couche d'émission (150) et la couche d'anode (120),
- la première sous-couche d'anode (121) est disposée plus proche du substrat (110), et
- la seconde sous-couche d'anode (122) est disposée plus proche de la couche d'injection de trous (130) ;
les composés A1 à A18 étant exclus de la formule (I) :

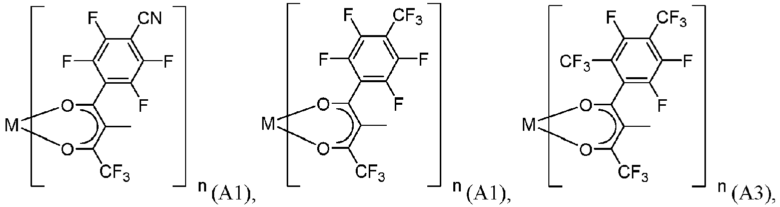

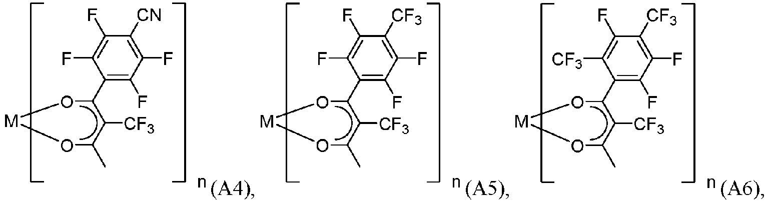

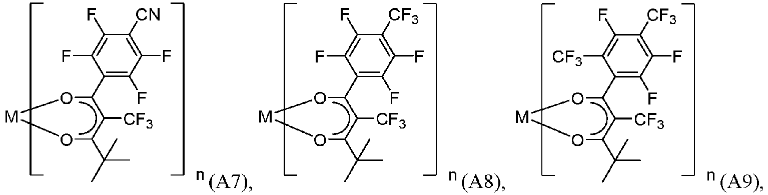

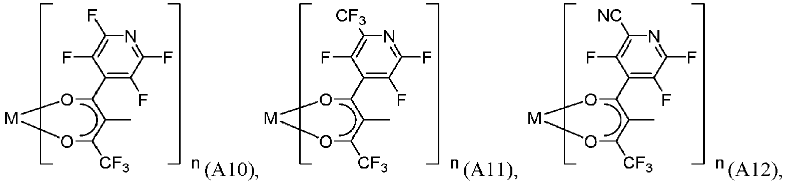

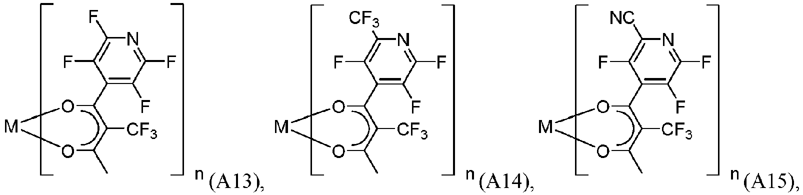

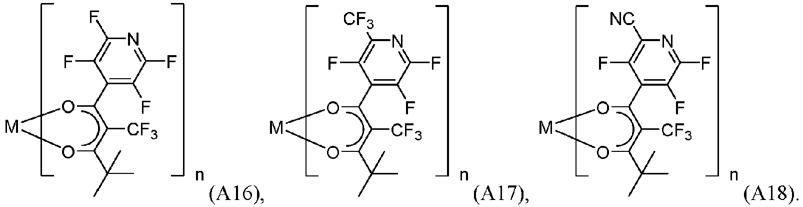

2. Dispositif électronique organique (100) selon la revendication 1, R² étant choisi parmi CN, CH₃, CF₃, C₂F₅, C₃F₇ ou F, plus préférablement CN, CH₃, CF₃, C₂F₅, C₃F₇.

3. Dispositif électronique organique (100) selon la revendication 1 ou 2, au moins un groupe R¹ et/ou R³ étant choisi parmi un groupe aryle en C₆ à C₂₄ substitué ou hétéroaryle en C₂ à C₂₄ substitué, au moins un substituant ou au moins deux substituants du groupe aryle en C₆ à C₂₄ substitué ou hétéroaryle en C₂ à C₂₄ substitué étant choisis parmi CN ou un alkyle en C₁ à C₁₂ partiellement ou totalement fluoré, de préférence un alkyle en C₁ à C₄ partiellement ou totalement fluoré, et plus préférablement choisi parmi CN, CF₃, C₂F₅ ou C₃F₇.

4. Dispositif électronique organique (100) selon l'une quelconque des revendications 1 à 3, au moins un groupe R¹ ou R³, ou R¹ et R³ étant choisi parmi un groupe hétéroaryle en C₂ à C₂₄ substitué,
- le groupe hétéroaryle substitué comprenant au moins un cycle à six chaînons ; et/ou
- le groupe hétéroaryle substitué comprenant au moins 1 à 6 atomes d'azote, de préférence 1 à 3 atomes d'azote, et plus préférablement 1 atome d'azote ; et/ou
- le groupe hétéroaryle du groupe hétéroaryle substitué étant un cycle à six chaînons, comprenant 1, 2 ou 3 hétéroatomes, l'hétéroatome étant de préférence N.

5. Dispositif organique électronique (100) selon l'une quelconque des revendications 1 à 4, au moins un groupe aryle en C₆ à C₂₄ substitué ou non substitué ou un groupe hétéroaryle en C₂ à C₂₄ substitué ou non substitué de R¹ et/ou R³ étant choisi parmi les formules D1 à D71 suivantes : 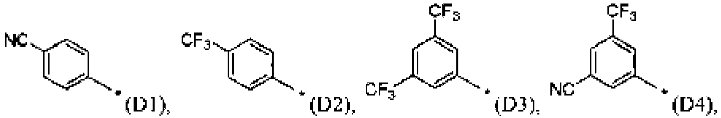 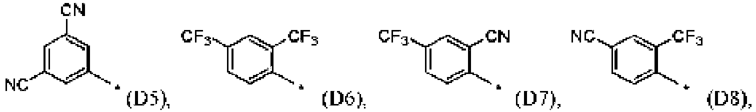 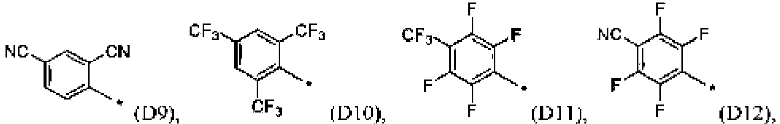 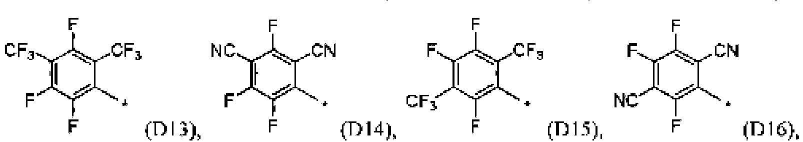 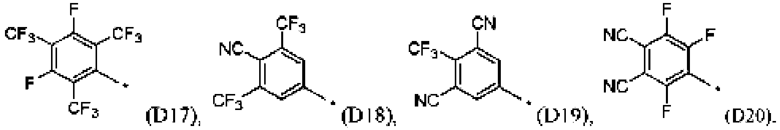 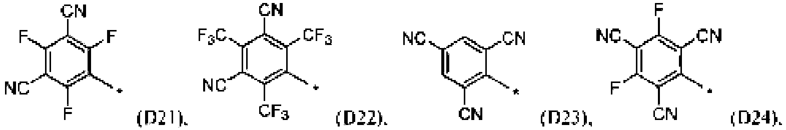 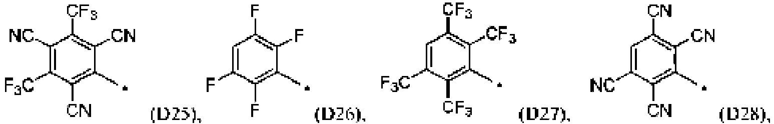 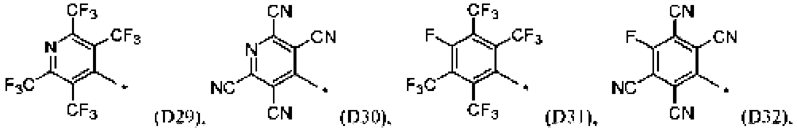 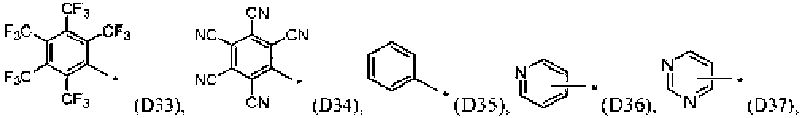 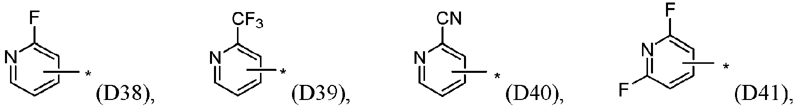 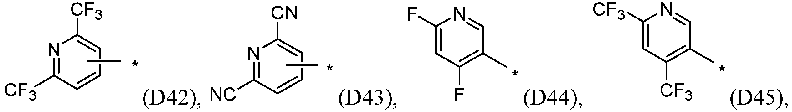 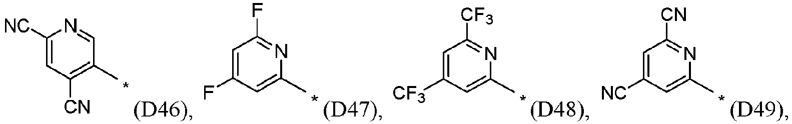 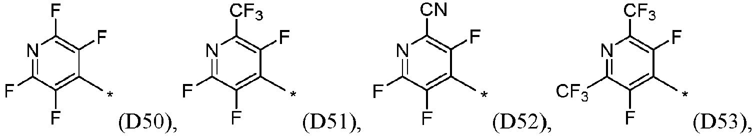 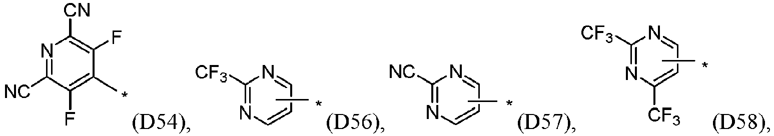 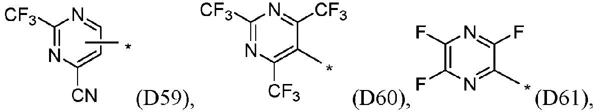 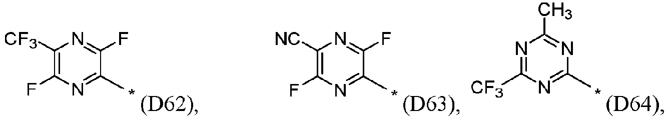 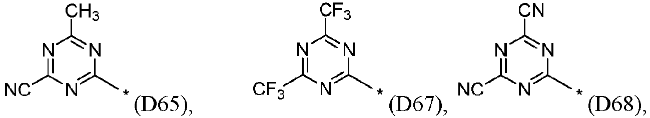 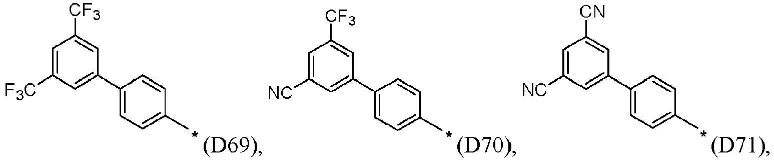 dans lesquelles « * » désigne la position de liaison.

6. Dispositif électronique organique (100) selon l'une quelconque des revendications 1 à 5, le complexe métallique étant représenté par la formule I et étant choisi parmi les formules E1 à E20 suivantes : 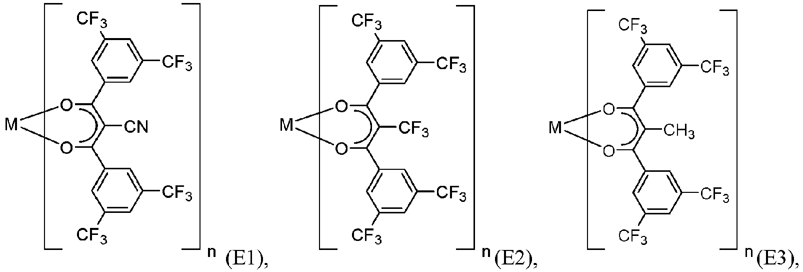 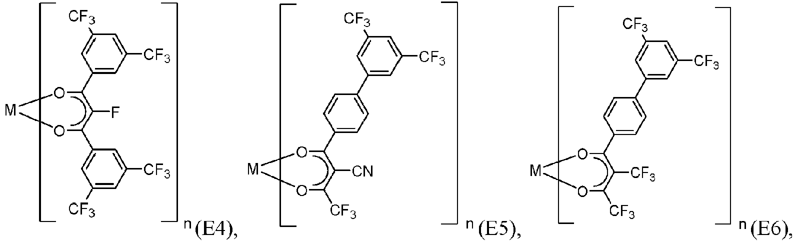 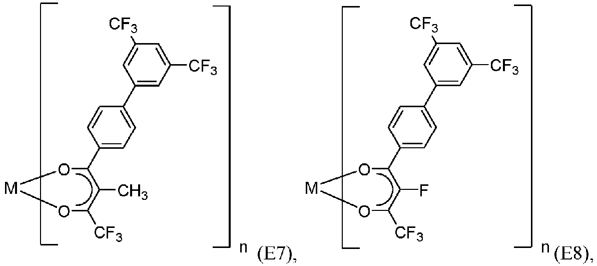 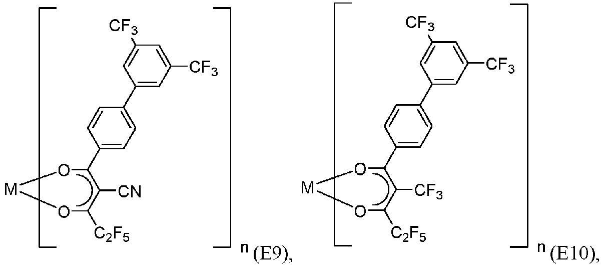 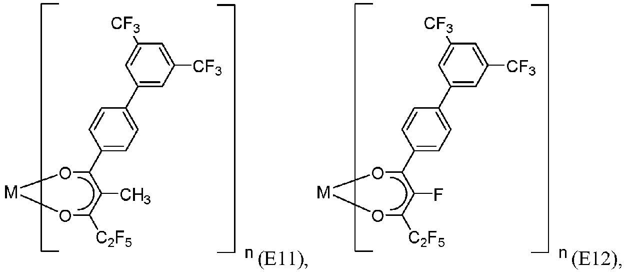 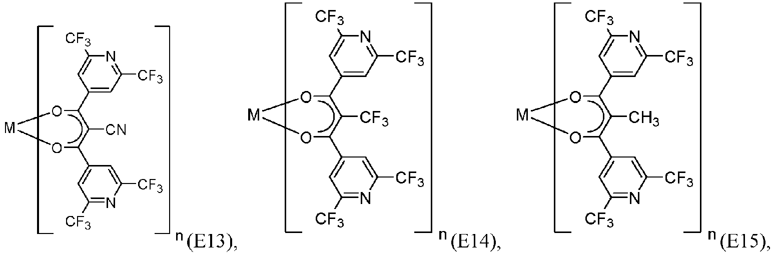 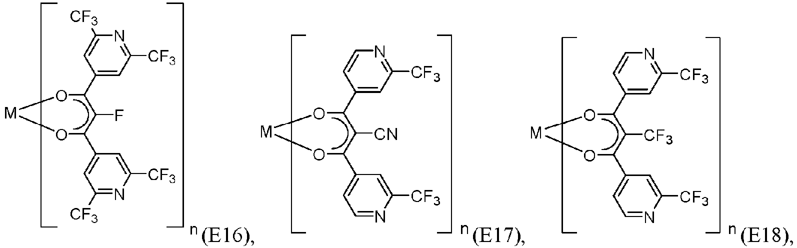 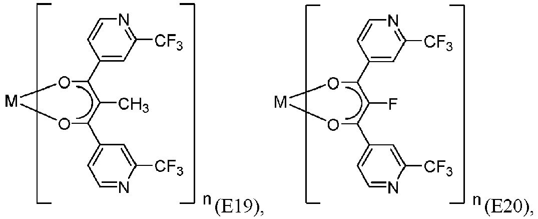 et plus préférablement, M étant Cu(II) ou Fe(III).

7. Dispositif électronique organique (100) selon l'une quelconque des revendications 1 à 6, le complexe métallique étant représenté par la formule I et étant choisi parmi les formules G1 à G7 suivantes :

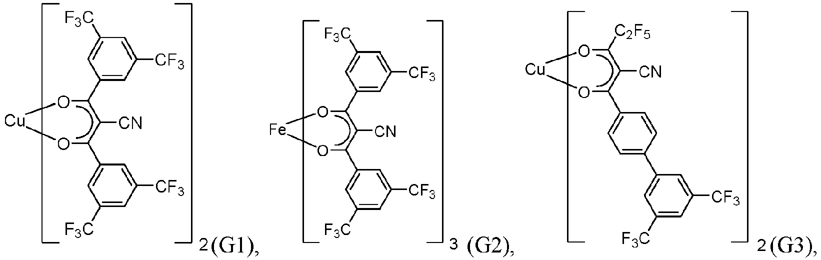

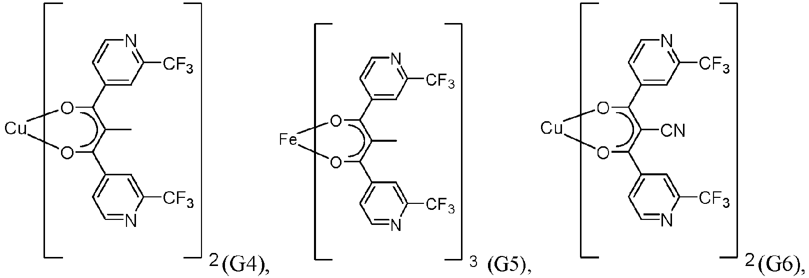

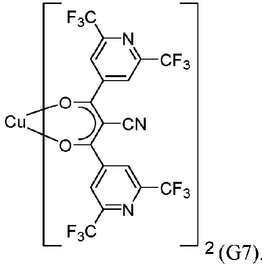

8. Dispositif électronique organique (100) selon l'une quelconque des revendications 1 à 6, le métal M étant choisi parmi un métal alcalin, un métal alcalinoterreux, un métal de transition, un métal de terres rares ou un métal des groupes III à V, de préférence le métal M étant choisi parmi un métal des groupes III à V ; de préférence le métal M étant choisi parmi Li(I), Na(I), K(I), Rb(I), Cs(I), Cu(II), Zn(II), Pd(II), Al(III), Sc(III), Mn(III), In(III), Y(III), Eu(III), Fe(III), Zr(IV), Hf(IV) ou Ce(IV), plus préférablement M étant Cu(II) ou Fe(III), et encore plus préférablement M étant Cu(II).

9. Dispositif électronique organique (100) selon l'une quelconque des revendications 1 à 5 et 8, L étant choisi dans le groupe comprenant H₂O des éthers en C₂ à C₄₀ et thioéthers en C₂ à C₄₀ mono- ou multidentés, des amines en C₂ à C₄₀, une phosphine en C₂ à C₄₀, un alkylnitrile en C₂ à C₂₀ ou un arylnitrile en C₂ à C₄₀, ou un composé répondant à la formule (II) ; 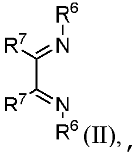 dans laquelle
R⁶ et R⁷ sont indépendamment choisis parmi un alkyle en C₁ à C₂₀, un hétéroalkyle en C₁ à C₂₀, un aryle en C₆ à C₂₀, un hétéroaryle avec 5 à 20 atomes formant le cycle, un alkyle en C₁ à C₂₀ halogéné ou perhalogéné, un hétéroalkyle en C₁ à C₂₀ halogéné ou perhalogéné, un aryle en C₆ à C₂₀ halogéné ou perhalogéné, un hétéroaryle halogéné ou perhalogéné avec 5 à 20 atomes formant le cycle, ou bien au moins un groupe R⁶ et un groupe R⁷ sont pontés et forment un cycle à 5 à 20 chaînons, ou bien les deux groupes R⁶ et/ou les deux groupes R⁷ sont pontés et forment un cycle à 5 à 40 chaînons ou forment un cycle à 5 à 40 chaînons comprenant une phénanthroline non substituée ou substituée par un groupe en C₁ à C₁₂.

10. Dispositif électronique organique (100) selon l'une quelconque des revendications 1 à 9, n étant un entier choisi parmi 1, 2 et 3, de préférence 2, qui correspond à l'indice d'oxydation de M.

11. Dispositif électronique organique (100) selon l'une quelconque des revendications 1 à 5 et 8 à 10, m étant un nombre entier choisi parmi 0 ou 1, préférablement 0.

12. Dispositif électronique organique (100) selon l'une quelconque des revendications 1 à 11 précédentes, le dispositif électronique organique (100) comprenant en outre une couche de transport de trous (140), la couche de transport de trous (140) étant disposée entre la couche d'injection de trous (130) et l'au moins une couche d'émission (150).

13. Dispositif électronique organique (100) selon la revendication 12, la couche de transport de trous (140) comprenant un composé de matrice covalente, de préférence un composé de matrice sensiblement covalente, le composé de matrice covalente, de préférence le composé de matrice sensiblement covalente, dans la couche d'injection de trous (130) et la couche de transport de trous (140), étant choisis de manière identique.

14. Dispositif électronique organique selon (100) l'une quelconque des revendications 1 à 13 précédentes, le dispositif électronique organique (100) étant un dispositif émetteur de lumière ou un dispositif d'affichage.
